(19) Europäisches Patentamt
European Patent Office
Office européen des brevets

(11) **EP 2 300 900 B1**

(12) **EUROPÄISCHE PATENTSCHRIFT**

(45) Veröffentlichungstag und Bekanntmachung des Hinweises auf die Patenterteilung:
**05.09.2018  Patentblatt 2018/36**

(51) Int Cl.:
*G06F 3/044* *(2006.01)*    *G06F 3/041* *(2006.01)*
*G06F 3/045* *(2006.01)*    *H03K 17/955* *(2006.01)*

(21) Anmeldenummer: **10724091.3**

(86) Internationale Anmeldenummer:
**PCT/EP2010/058418**

(22) Anmeldetag: **15.06.2010**

(87) Internationale Veröffentlichungsnummer:
**WO 2010/149543 (29.12.2010 Gazette 2010/52)**

(54) **ELEKTRODENANORDNUNG FÜR ANZEIGEEINRICHTUNG**

ELECTRODE ARRANGEMENT FOR DISPLAY DEVICE

AGENCEMENT D'ÉLECTRODES POUR DISPOSITIF D'AFFICHAGE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **24.06.2009   DE 102009030495**
**30.10.2009   DE 102009051409**

(43) Veröffentlichungstag der Anmeldung:
**30.03.2011   Patentblatt 2011/13**

(73) Patentinhaber: **Microchip Technology Germany GmbH**
**82205 Gilching (DE)**

(72) Erfinder:
• **KANDZIORA, Thomas**
**86947 Schwabhausen (DE)**
• **FASSHAUER, Peter**
**85579 Neubiberg (DE)**

(74) Vertreter: **sgb europe**
**Lechnerstraße 25a**
**82067 Ebenhausen (DE)**

(56) Entgegenhaltungen:
**US-A1- 2005 126 831    US-A1- 2006 132 462**
**US-A1- 2008 018 608    US-A1- 2008 316 182**
**US-A1- 2009 096 761**

## Beschreibung

### Gebiet der Erfindung

Die Erfindung betrifft eine Elektrodenanordnung für eine kapazitive Sensoreinrichtung bzw. für einen kapazitiven Sensor zum Erfassen einer Position und/oder einer Annäherung eines Objektes. Insbesondere betrifft die Erfindung eine Elektrodenkonfiguration für eine Anzeigeeinrichtung zum Erfassen einer Position und/oder einer Annäherung eines Objektes an der/die Anzeigeeinrichtung unter Verwendung der erfindungsgemäßen Elektrodenanordnung. Des Weiteren betrifft die Erfindung eine Folie, auf welcher Bestandteile des System, insbesondere Elektroden angeordnet sind. Des Weiteren betrifft die Erfindung ein Verfahren zur Herstellung einer annäherungssensitiven Anzeigeeinrichtung unter Verwendung eines berührungssensitiven Bildschirms und unter Verwendung der erfindungsgemäßen Folie.

### Stand der Technik

Bei Bildschirmen bzw. Displays, insbesondere bei Computerbildschirmen, mobilen Kommunikationsgeräten oder Navigationsgeräten besteht der Wunsch, die Funktionalität der Bildschirme durch eine Erkennung der Annäherung an den Bildschirm oder eine Erkennung von Gesten in der Nähe des Bildschirms zu erweitern, um hierdurch beispielsweise Bildbewegungen wie das Blättern und/oder Drehen von auf dem Bildschirm dargestellten elektronischen Dokumenten von Hand zu steuern, ohne dabei den Bildschirm zu berühren.

Eine Lösung bieten sog. kapazitive Systeme. Diese bekannten Lösungen haben aber den Nachteil, dass sie nur eine geringe Empfindlichkeit aufweisen, sodass nur eine ungenaue Erkennung von Gesten möglich ist. Hinzu kommt, dass bei größeren Bildschirmen, wie sie z.B. in Büroarbeitsplätzen eingesetzt werden, eine Gestenerkennung auf kapazitiver Basis im Bereich der Bildschirmmitte nur mit zusätzlichen, im Bereich der Bildschirmmitte angeordneten kapazitiven Sensoren möglich ist, was den Aufwand der Auswertung zusätzlich erhöht.

Aus der US 2009/0096761 A1 ist eine berührungssensitive Eingabeeinrichtung für ein Display bekannt. Die berührungssensitive Eingabeeinrichtung weist einen transparenten Träger auf, wobei auf einer ersten Oberfläche des Trägers eine Sensorelektrode angeordnet ist und wobei auf einer zweiten Oberfläche des Trägers eine Schirmelektrode angeordnet ist. Die Sensorelektrode wird über eine Spannungs-Beaufschlagungselektrode mit einem elektrischen Signal beaufschlagt, welches durch einen die Sensorelektrode berührenden Finger beeinflusst wird.

Aus der US 2008/0018608 A1 ist eine berührungssensitive Eingabeeinrichtung bekannt, welche zwei zueinander beabstandete Trägerschichten aufweist, wobei zwischen den beiden Trägerschichten zwei Sensorelektroden angeordnet sind. Eine auf eine Trägerschicht einwirkende Kraft bewirkt, dass zwischen den beiden Sensorelektroden ein elektrischer Kontakt hergestellt wird, was mittels einer Auswerteeinrichtung detektiert werden kann.

Aus der US 2006/0132462 A1 ist eine berührungssensitive Eingabeeinrichtung bekannt, welche ein Trägersubstrat aufweist, auf dem eine resistive Schicht aufgebracht ist. Auf die resistive Schicht sind wiederum Elektroden angeordnet, über welche die resistive Schicht mit einem elektrischen Signal beaufschlagt wird. Eine Berührung der resistiven Schicht mit einem Finger bewirkt, dass das der resistiven Schicht beaufschlagte elektrische Signal eine Änderung erfährt, welche detektiert werden kann, wobei die Änderung indikativ für die Position einer Berührung auf der resistiven Schicht ist.

Des Weiteren besteht der Wunsch, berührungssensitive Bildschirme um die Funktionalität einer Annäherungsbzw. Gestenerkennung zu erweitern, um so auch bei berührungssensitiven Bildschirmen Anwendungen berührungslos von Hand steuern bzw. zu bedienen zu können.

### Aufgabe der Erfindung

Aufgabe der Erfindung ist es daher, eine Elektrodenanordnung für eine kapazitive Sensoreinrichtung bzw. einen kapazitiven Sensor zum Erfassen einer Position und/oder einer Annäherung eines Objektes, insbesondere einer Hand oder eines Fingers bereitzustellen, welche die genannten Nachteile zumindest teilweise vermeidet und eine verbesserte Empfindlichkeit der kapazitiven Sensoreinrichtung bzw. des kapazitiven Sensors sowie eine nachträgliche Erweiterung von Anzeigeeinrichtungen, insbesondere von berührungsempfindlichen Anzeigeeinrichtungen um annäherungssensitive bzw. Gestenfunktionalität ermöglicht.

### Erfindungsgemäße Lösung

Erfindungsgemäß wird diese Aufgabe durch die Gegenstände der unabhängigen Ansprüche gelöst. Vorteilhafte Ausgestaltungen der Erfindung sind in den jeweiligen abhängigen Ansprüchen angegeben.

Danach wird eine Elektrodenanordnung für eine kapazitive Sensoreinrichtung bzw. für einen kapazitiven Sensor zum Erfassen einer Position und/oder einer Annäherung eines Objektes, aufweisend eine Sensorelektrode und eine erste Schirmelektrode, bereitgestellt, wobei die Sensorelektrode auf einer ersten Seite eines im Wesentlichen flächig ausgestalteten Trägermaterials mit einer ersten Seite und einer zweiten Seite angeordnet ist, und wobei die erste Schirmelektrode auf der zweiten Seite des Trägermaterials angeordnet ist und zur Abschirmung des von der Sensorelektrode emittierten elektrischen Wechselfeldes gegen Masse dient.

Die Elektrodenanordnung kann eine zweite Schirmelektrode aufweisen, wobei die zweite Schirmelektrode auf der ersten Seite des Trägermaterials angeordnet ist, die Sensorelektrode mittels einer Leiterbahn, welche auf der ersten Seite des Trägermaterials angeordnet ist, mit einer Auswerteelektronik koppelbar ist, die zweite Schirmelektrode zwischen der Sensorelektrode und der Leiterbahn und beabstandet zur Sensorelektrode und zur Leiterbahn angeordnet ist und zur Abschirmung eines von der Sensorelektrode emittierten elektrischen Wechselfeldes gegen die Leiterbahn dient, und die Sensorelektrode, die zweite Schirmelektrode und die Leiterbahn jeweils streifenförmig ausgestaltet sind, wobei die zweite Schirmelektrode breiter ist als die Leiterbahn.

Die Sensorelektrode kann breiter sein als die Leiterbahn.

Die Sensorelektrode kann breiter sein als die zweite Schirmelektrode.

Diese Elektrodenanordnung zeichnet sich insbesondere dadurch aus, dass eine verbesserte Empfindlichkeit des kapazitiven Sensorsystems gegenüber herkömmlichen kapazitiven Sensorsystemen erreicht wird. Mit der ersten Schirmelektrode kann das elektrische Feld der Sensorelektrode gegen das Massepotential des Bildschirms abgeschirmt werden, was die Sensivität deutlich erhöht. Weil die zweite Schirmelektrode breit im Verhältnis zur Leiterbahn ist, wird der Einfluss der Leiterbahn auf die Sensorelektrode minimiert bzw. besonders gering gehalten. Zusätzliche Mittel zum Abschirmen der Leiterbahn sind nicht notwendig, was die Herstellung der Elektrodenanordnung und die Integration der Elektrodenanordnung in ein Zielsystem vereinfacht. Weil die Sensorelektrode breit im Verhältnis zur Leiterbahn ist, wird eine hohe Empfindlichkeit der Sensorelektrode erreicht.

Die Elektrodenanordnung kann eine dritte Schirmelektrode aufweisen, wobei die dritte Schirmelektrode auf der ersten Seite des Trägermaterials beabstandet zur Leiterbahn angeordnet ist, wobei die Leiterbahn zwischen der zweiten Schirmelektrode und der dritten Schirmelektrode angeordnet ist. In vorteilhafter Weise wird so der seitliche Einfluss auf die Sensorelektrode weiter verringert bzw. eliminiert.

Die Sensorelektrode, die zweite Schirmelektrode und die Leiterbahn können im Wesentlichen parallel zueinander angeordnet sein. Dadurch verändert sich der Einfluss der Leitbahn auf die Sensorelektrode entlang der Leiterbahn nicht, was eine einfachere Konfiguration der zwischen der Sensorelektrode und der Leitbahn angeordneten zweiten Schirmelektrode ermöglicht.

Die erste Schirmelektrode kann durch ein leitfähiges und weitgehend transparentes Material gebildet werden. Die erste Schirmelektrode kann dabei wesentlich breiter ausgestaltet sein als die Gesamtbreite von Sensorelektrode, zweiter Schirmelektrode, dritter Schirmelektrode und Leiterbahn, sodass auch für Anzeigeeinrichtungen ohne elektrisch leitfähige Beschichtungen eine besonders sensitive Detektion möglich ist.

Die erste Schirmelektrode kann mit einer leitfähigen und weitgehend transparenten Schicht galvanisch oder kapazitiv koppelbar sein. Damit können herkömmliche berührungsempfindliche Bildschirme mit einer Gesten- bzw. Annäherungsdetektion ausgerüstet werden, wobei die elektrische leitfähige Beschichtung des berührungsempfindlichen Bildschirmes genutzt wird, um die Elektrodenkonfiguration gegen die Masse des Bildschirms abzuschirmen.

Die Sensorelektrode kann mit einem Resonanzkreis gekoppelt sein, wobei das unter Einschluss der Sensorelektrode und des Resonanzkreises gebildete System mit einer elektrischen Spannung beaufschlagbar ist, wobei eine Phasenverschiebung einer elektrischen Spannung des Resonanzkreises gegenüber der beaufschlagten elektrischen Spannung indikativ für die Annäherung und/oder die Position des Objektes an der Sensorelektrode ist.

Ein Ausgang des unter Einschluss der Sensorelektrode und des Resonanzkreises gebildeten Systems kann über eine Verstärkerschaltung auf zumindest eine der drei Schirmelektroden schaltbar sein, um zumindest eine der drei Schirmelektroden im Wesentlichen auf das elektrische Potential der Sensorelektrode zu bringen.

In einer Ausführungsform ist ein Ausgang des unter Einschluss der Sensorelektrode und des Resonanzkreises gebildeten Systems über eine Treiberschaltung auf alle drei Schirmelektroden schaltbar, um alle drei Schirmelektroden im Wesentlichen auf das elektrische Potential der Sensorelektrode zu bringen.

Die Verstärkerschaltung kann als Treiberschaltung ausgestaltet sein. Die Treiberschaltung kann ausgestaltet sein, den Strom an der zumindest einen Schirmelektrode zu treiben und die zumindest eine Schirmelektrode mit einer zur Elektrodenspannung der Sensorelektrode phasengleichen elektrischen Spannung zu beaufschlagen, wobei die beaufschlagte elektrische Spannung vorzugweise betragsmäßig kleiner ist als die Elektrodenspannung der Sensorelektrode.

Damit kann ein nahezu feldfreier Raum zwischen der Sensorelektrode und den Schirmelektroden erzeugt werden, was sich wiederum positiv auf die Empfindlichkeit des kapazitiven Sensorsystems auswirkt.

Die zumindest eine Koppelelektrode kann zwischen der Sensorelektrode und der ersten Schirmelektrode angeordnet sein und mit der ersten Schirmelektrode gekoppelt sein. Der Ausgang des zumindest einen kapazitiven Sensors kann über die Treiberschaltung auf die Koppelelektrode schaltbar sein, um die Koppelelektrode und die erste Schirmelektrode im Wesentlichen auf das elektrische Potential der Sensorelektrode zu bringen.

Die Treiberschaltung kann ausgestaltet sein, den Strom an der Koppelelektrode zu treiben und die Koppelektrode mit einer zur Elektrodenspannung der Sensorelektrode phasengleichen elektrischen Spannung zu beaufschlagen, wobei die beaufschlagte elektrische Spannung betragsmäßig kleiner ist als die Elektrodenspannung der Sensorelektrode.

Die Schirmelektrode und die Koppelelektrode können kapazitiv koppelbar sein.

Mehrere Sensorelektroden können über einen Multiplexer mit der Treiberschaltung gekoppelt sein.

Die induktive Komponente des Resonanzkreises kann durch einen Gyrator gebildet werden.

Der Gyrator kann einen über einen Kondensator rückgekoppelten Operationsverstärker umfassen, welcher am Eingang des kapazitiven Sensors als virtuelle Induktivität wirkt, wobei die virtuelle Induktivität zusammen mit der am Eingang des kapazitiven Sensors angeschlossenen Sensorelektrode und deren Lastkapazität gegen Masse einen Parallelschwingkreis bildet.

Der Ausgang des Operationsverstärkers kann mit der Verstärkerschaltung koppelbar sein, wobei am Ausgang des Operationsverstärkers ein Dämpfungsglied, vorzugsweise ein ohmscher Spannungsteiler, angeordnet ist.

Bereitgestellt wird auch eine Elektrodenkonfiguration für eine Anzeigeeinrichtung zum Erfassen einer Position und/oder einer Annäherung eines Objektes an der/die Anzeigeeinrichtung, umfassend zumindest eine erfindungsgemäße Elektrodenanordnung, wobei die Elektrodenanordnung so an der Anzeigeeinrichtung anordenbar ist, dass die zweite Seite des Trägermaterials der Anzeigeeinrichtung zugewandt ist und wobei die erste Schirmelektrode der Abschirmung des von der Sensorelektrode emittierten elektrischen Wechselfeldes gegenüber der geerdeten Anzeigeeinrichtung dient.

Die erste Schirmelektrode kann mit einer vor der Anzeigeeinrichtung angeordneten leitfähigen und weitgehend transparenten Schicht galvanisch oder kapazitiv koppelbar sein.

Die erste Schirmelektrode kann durch eine vor der Anzeigeeinrichtung angeordnete leitfähige und weitgehend transparente Schicht gebildet werden.

Die Elektrodenanordnung kann randseitig um die Anzeigeeinrichtung umlaufend angeordnet sein, wobei die Sensorelektrode aus zumindest vier voneinander getrennten Sensorelektrodensegmenten gebildet wird, welche jeweils mit einer Auswerteelektronik koppelbar sind, und wobei jeweils ein Sensorelektrodensegment entlang jeweils einer Kante der Anzeigeeinrichtung angeordnet ist. Damit lassen sich X- und Y-Koordinate eines sich annähernden Fingers bestimmen.

Bereitgestellt wird auch eine Vorrichtung zum Erfassen von Gesten, der Position und/oder der Annäherung eines Objektes an einer Anzeigeeinrichtung, mit einer erfindungsgemäßen Elektrodenanordnung, wobei die erste Schirmelektrode in ein transparentes Schutzmaterial eingebettet ist, welches an der Anzeigeeinrichtung anordenbar ist, und wobei die erste Schirmelektrode der Abschirmung des Elektrodenfelds der Sensorelektrode gegenüber der geerdeten Anzeigeeinrichtung dient.

Die erste Schirmelektrode und die zumindest eine Sensorelektrode kann jeweils in ein Trägermaterial eingebettet sein und die Träger können an der der Anzeigeeinrichtung abgewandten Oberfläche des transparenten Schutzmaterials angeordnet sein. Das Trägermaterial kann ein transparentes Trägermaterial sein.

Die Anzeigeeinrichtung kann ein berührungssensitiver Bildschirm sein, wobei die erste Schirmelektrode durch die leitfähigen Strukturen des berührungssensitiven Bildschirms gebildet wird, wobei die leitfähigen Strukturen des berührungssensitiven Bildschirms im Zeitmultiplexverfahren mit einer Auswerteeinheit zur Berührungsdetektion und mit einer Auswerteeinheit zur Annäherungsdetektion gekoppelt sind. Es kann so ein Bildschirm bereit gestellt werden, welcher sowohl die Berührung als auch die Annäherung bzw. eine Geste, welche vor dem Bildschirm ausgeführt wird, detektieren kann.

Die Vorrichtung kann ausgestaltet sein, oberhalb eines vorbestimmten ersten Abstandes des Objektes zur Anzeigeeinrichtung eine Bewegung des Objektes relativ zur Anzeigeeinrichtung auszuwerten.

Die Auswerteeinheit zur Annäherungsdetektion kann deaktivierbar sein, wenn der Abstand des Objektes zur Anzeigeeinrichtung kleiner ist als der erste Abstand.

Die Vorrichtung kann ausgestaltet sein, unterhalb eines vorbestimmten zweiten Abstandes des Objektes zur Anzeigeeinrichtung ein Berühren der Anzeigeeinrichtung durch das Objekt auszuwerten.

Vorteilhafterweise ist der zweite Abstand größer als der erste Abstand.

Bereitgestellt wird auch eine Folie mit einer ersten Seite und einer zweiten Seite, wobei auf der ersten Seite der Folie eine Sensorelektrode oder eine Mehrzahl von Sensorelektroden angeordnet sind, auf der ersten Seite zumindest eine zweite Schirmelektrode angeordnet ist, und auf der ersten Seite eine Leiterbahn zum Verbinden der Sensorelektrode mit einer Auswerteelektronik angeordnet ist, wobei die zweite Schirmelektrode zwischen der Leiterbahn und der Sensorelektrode angeordnet ist. Auf der zweiten Seite der Folie ist zumindest eine erste Schirmelektrode angeordnet.

Bereitgestellt wird auch ein Verfahren zur Herstellung einer annäherungssensitiven Anzeigeeinrichtung mit einem berührungssensitiven Bildschirm, wobei der berührungssensitive Bildschirm leitfähige Strukturen zur Detektion einer Berührung aufweist, umfassend einen Schritt zum Aufbringen einer erfindungsgemäßen Folie auf den berührungssensitiven Bildschirm, wobei die zumindest eine Koppelelektrode dem Bildschirm zugewandt wird und wobei die zumindest eine Koppelelektrode mit den leitfähigen Strukturen des berührungssensitiven Bildschirms in eine kapazitive Kopplung bringbar sind.

Die Folienanschlüsse und die leitfähigen Strukturen des berührungssensitiven Bildschirms werden mit einer Auswerteeinheit zur Annäherungsdetektion gekoppelt, wobei die leitfähigen Strukturen im Zeitmultiplexverfahren mit der Auswerteeinheit zur Annäherungsdetektion und mit einer Auswerteeinheit zur Berührungsdetektion gekoppelt werden.

Weitere Vorteile und vorteilhafte Ausgestaltungen der Erfindung sind der Beschreibung, der Zeichnung und den Patentansprüchen entnehmbar.

**Kurzbeschreibung der Figuren**

In der Zeichnung sind Ausführungsbeispiele schematisch vereinfacht dargestellt und werden in nachfolgender Beschreibung näher erläutert. Es zeigt:

Fig. 1     einen Schichtenaufbau einer erfindungsgemäßen Elektrodenanordnung, mit zwei Elektrodenschichten, wobei eine Elektrodenschicht an eine leitfähige Schicht einer Anzeigeeinrichtung galvanisch gekoppelt ist;

Fig. 2     einen Schichtenaufbau einer erfindungsgemäßen Elektrodenanordnung mit zwei Schichten, wobei eine Elektrode kapazitiv an eine leitfähige Schicht einer Anzeigeeinrichtung gekoppelt ist;

Fig. 3     eine erfindungsgemäße Elektrodenkonfiguration für eine Anzeigeeinrichtung in der Draufsicht;

Fig. 4     einen Ausschnitt der in Figur 3 gezeigten Elektrodenkonfiguration;

Fig. 5     eine erfindungsgemäße Elektrodenkonfiguration für kleine Anzeigeeinrichtungen, welche keine leitfähige Schicht aufweisen;

Fig. 6     eine weitere erfindungsgemäße Ausgestaltung einer Elektrodenanordnung, wobei eine Elektrode durch eine leitfähige Schicht einer Anzeigeeinrichtung gebildet wird;

Fig. 7     ein kapazitives Ersatzschaltbild für einen kapazitiven Sensor mit einer Sensorelektrode und einer Schirmelektrode;

Fig. 8     eine Prinzipanordnung eines erfindungsgemäßen Systems bzw. einer Schaltungsanordnung mit mehreren kapazitiven Sensoren;

Fig. 9     ein kapazitives Ersatzschaltbild für einen kapazitiven Sensor aus Fig. 8;

Fig. 10   ein kapazitives Ersatzschaltbild für einen kapazitiven Sensor mit einem sich dem kapazitiven Sensor annähernden Finger;

Fig. 11   eine als Gyrator ausgestaltete induktive Komponente des Resonanzkreises eines kapazitiven Sensors;

Fig. 12   eine rahmenförmige Anordnung der Elektroden des erfindungsgemäßen Systems;

Fig. 13   einen Schichtenaufbau der im Fig. 12 gezeigten rahmenförmigen Anordnung der Elektroden des erfindungsgemäßen Systems;

Fig. 14   den Grundaufbau eines resistiven berührungssensitiven Bildschirms;

Fig. 15   eine Verschaltung eines berührungssensitiven Bildschirms mit einer Auswerteeinheit zur Berührungsdetekion;

Fig. 16   eine erfindungsgemäße Verschaltung eines berührungssensitiven Bildschirms mit einer Auswerteeinrichtung zur Berührungsdetektion und einer Auswerteelektronik zur Annäherungsdetektion;

Fig. 17   ein Beispiel für eine Annäherungs- und Berührungsdetektion in Abhängigkeit von dem Abstand eines Objektes zu einem berührungssensitiven Bildschirm;

Fig. 18    die Verwendung leitfähiger Strukturen eines berührungssensitiven Bildschirms als Schirmelektroden für eine erfindungsgemäße Elektrodenkonfiguration, wobei die Elektroden rahmenförmig angeordnet sind; und

Fig. 19    die Verwendung leitfähiger Strukturen eines berührungssensitiven Bildschirms als Schirmelektroden für das erfindungsgemäße System, wobei die Sensorelektrode als leitfähige Folie ausgestaltet ist.

## Detaillierte Beschreibung der Erfindung

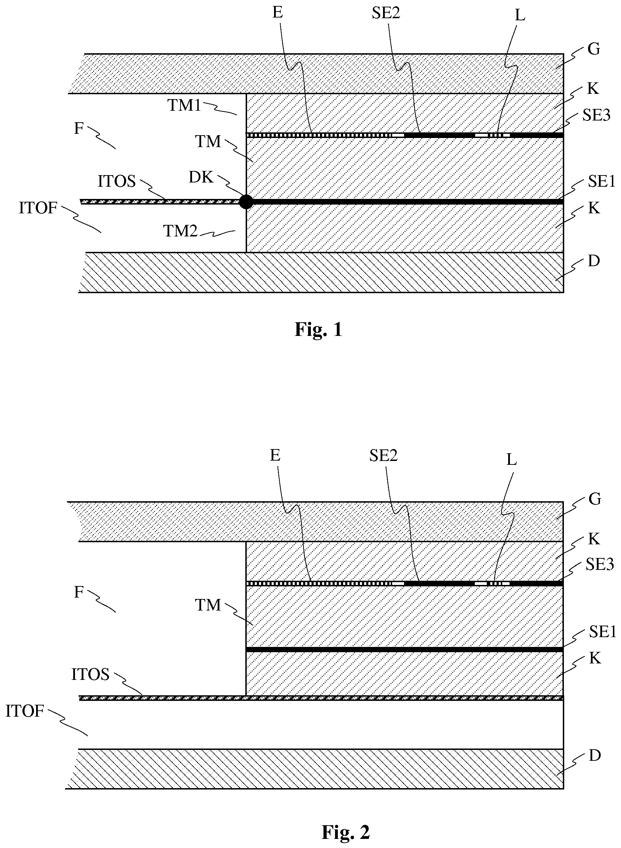

**Fig. 1** zeigt einen erfindungsgemäßen Schichtenaufbau einer Elektrodenanordnung für eine kapazitive Sensoreinrichtung bzw. für einen kapazitiven Sensor zum Erfassen einer Position und/oder einer Annäherung eines Objektes, etwa einer Hand oder eines Fingers. Die Elektrodenanordnung umfasst zumindest eine erste Schirmelektrode SE1, eine zweite Schirmelektrode SE2 und eine Sensorelektrode E.

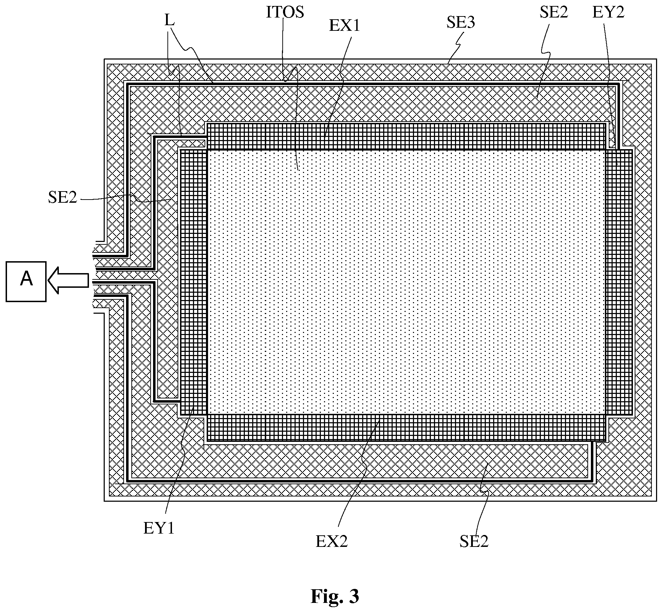

An der Oberseite eines Trägermaterials TM ist eine Sensorelektrode E und eine zweite Schirmelektrode SE2 angeordnet. Auf der zweiten Seite des Trägermaterials TM, d.h. auf der Unterseite des Trägermaterials ist eine erste Schirmelektrode SE1 angeordnet. Eine Leiterbahn L, welche die Sensorelektrode E mit einer Auswerteelektronik A koppelt (vgl. Fig. 3), ist ebenfalls auf der ersten Seite, d.h. auf der Oberseite des Trägermaterials TM angeordnet. An der Oberseite des Trägermaterials TM ist ebenfalls eine dritte Schirmelektrode SE3 angeordnet. Die Anordnung der an der Oberseite des Trägermaterials TM angeordneten Elektroden E, SE2 und SE3 sowie der Leiterbahn L ist so gewählt, dass die zweite Schirmelektrode SE2 zwischen der Sensorelektrode E und der Leiterbahn L verläuft und die Leiterbahn L zwischen der zweiten Schirmelektrode SE2 und der dritten Schirmelektrode SE3 verläuft.

Als Trägermaterial TM kann ein beliebiges, nicht elektrisch leitfähiges Material verwendet werden. Vorzugsweise wird als Trägermaterial TM eine Folie verwendet. Damit wird in vorteilhafter Weise eine Elektrodenanordnung bereitgestellt, welche aus nur zwei Elektrodenschichten besteht, welche letztlich nur durch das Trägermaterial TM voneinander getrennt sind. Die Herstellung einer solchen zweilagigen Elektrodenstruktur kann besonders kostengünstig erfolgen. Zudem wird erreicht, dass das gesamte Elektrodendesign inklusive dem Trägermaterial TM besonders flach ausgestaltet werden kann, was eine besonders einfache mechanische Integration in das Zielsystem, etwa einem Bildschirm, ermöglicht.

Die an der Unterseite des Trägermaterials TM angeordnete erste Schirmelektrode SE1 ist galvanisch mit einer leitfähigen Schicht ITOS gekoppelt. Bei einer Anwendung der erfindungsgemäßen Elektrodenanordnung an einem berührungssensitiven Bildschirm kann die elektrisch leitfähige Schicht ITOS etwa die leitfähige Beschichtung vor dem sichtbaren Bereich des Bildschirms sein. Die Koppelung der leitfähigen Schicht bzw. die Kontaktierung der leitfähigen Schicht mit der ersten Schirmelektrode SE1 kann beispielsweise mittels einer Durchkontaktierung DK hergestellt werden.

Die Elektrodenanordnung kann beispielsweise mit einem Klebstoff K auf einen Bildschirm D befestigt werden. Die Befestigung erfolgt vorzugsweise derart, dass die Sensorelektrode E dem sichtbaren Bereich des Bildschirms zugeordnet ist bzw. dem zu überwachenden Bereich zugeordnet ist. An der dem Bildschirm D zugewandten Seite kann beispielsweise eine Glasplatte G angeordnet werden, wobei die Glasplatte beispielsweise mittels eines Klebers K an die erfindungsgemäße Elektrodenstruktur aufgebracht wird. Zwischen der Glasplatte G und der leitfähigen Schicht des berührungsempfindlichen Bildschirms kann eine Folie F zum Auffüllen vorgesehen sein, um einen Paralaxenfehler zu vermeiden. Die leitfähigen Schicht ITOS kann auf eine Folie, etwa eine ITO-Folie aufgebracht sein.

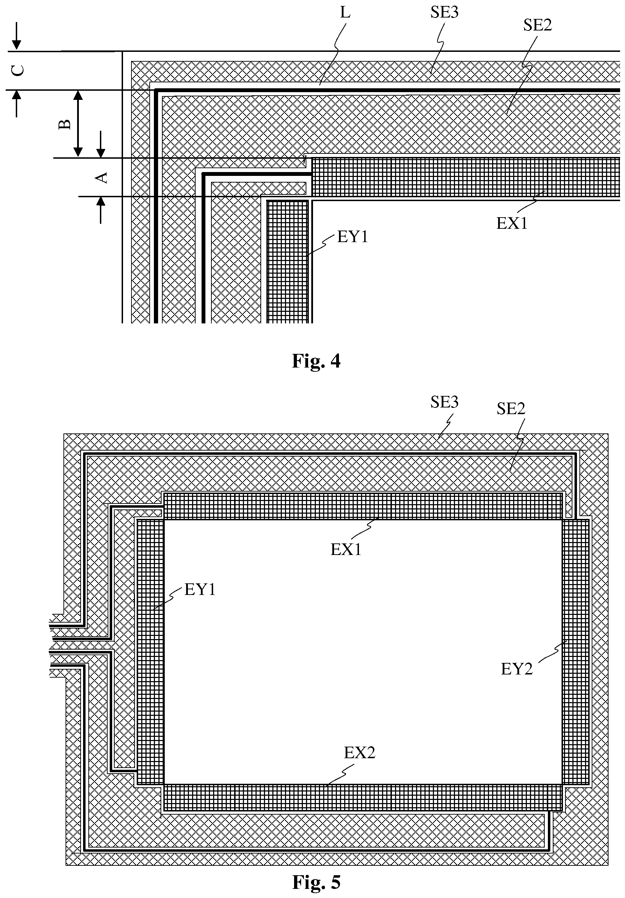

Zum Zwecke der Detektion wird an der Sensorelektrode E ein elektrisches Wechselfeld abgestrahlt, wobei eine Veränderung des abgestrahlten elektrischen Wechselfeldes indikativ für eine Annäherung bzw. eine Position eines Objektes an dem Bildschirm bzw. am Bildschirm ist. Mit Hilfe der zweiten Schirmelektrode SE2 wird die Sensorelektrode E gegen die Leiterbahn L abgeschirmt, so dass der Einfluss der Leiterbahn L auf ein Messsignal der Sensorelektrode E minimiert wird. Vorteilhafterweise ist die Leiterbahn L besonders schmal im Vergleich zur zweiten Schirmelektrode SE2 ausgestaltet, wie in Fig. 4 näher erläutert wird.

Die dritte Schirmelektrode SE3 ist dazu vorgesehen, Einflüsse von außen zu eliminieren bzw. zu minimieren.

Die an der Unterseite des Trägermaterials TM angeordnete erste Schirmelektrode SE1 dient dazu, die Sensorelektrode E gegen den Bildschirm abzuschirmen, d.h. das von der Sensorelektrode E emittierte elektrische Wechselfeld gegen das Massepotential (des Bildschirms) abzuschirmen. Durch die Koppelung der ersten Schirmelektrode SE1 mit der leitfähigen Schicht ITOS des berührungsempfindlichen Bildschirms wird zudem der gesamte sichtbare Bereich des Bildschirms gegen Masse abgeschirmt, so dass eine Annäherung bzw. eine Gestendetektion auch in der Mitte des Bildschirms von den Sensorelektroden E noch gut detektierbar ist. Dies ist insbesondere bei großflächigen Anzeigeeinrichtungen von Vorteil.

Die elektrisch leitfähige Schicht ITOS des Bildschirms wird also auch dazu verwendet, um eine Abschirmung des von der Sensorelektrode E emittierten elektrischen Wechselfeldes gegen Masse des Bildschirms zu erreichen. Damit kann in einfacher Art und Weise ein berührungsempfindlicher Bildschirm um die Funktionalität einer Annäherungs- bzw. Gestendetektion erweitert werden, wobei insbesondere eine Annäherungs- bzw. Gestendetektion auch in der Mitte des sichtbaren Bereiches des Bildschirms möglich ist, ohne hierfür zusätzliche Maßnahmen, etwa zusätzliche Elektroden, vorsehen zu müssen.

**Fig. 2** zeigt einen Schichtenaufbau einer erfindungsgemäßen Elektrodenanordnung, wie bereits mit Bezug auf Fig. 1 gezeigt und beschrieben worden ist. Im Gegensatz zu der Ausführungsform der Fig. 1 ist bei der Ausführungsform nach Fig. 2 die leitfähige Schicht ITOS des Bildschirms nicht galvanisch an die erste Schirmelektrode SE1 gekoppelt, sondern kapazitiv. Dies hat den Vorteil, dass die Integration der erfindungsgemäßen Elektrodenanordnung in einen bestehenden Bildschirm besonders einfach bewerkstelligt werden kann. Insbesondere ist es dadurch möglich, dass die Elektrodenanordnung, d.h. das Trägermaterial TM und die auf dem Trägermaterial an der Oberseite und an der Unterseite angeordneten Elektroden bzw. Leiterbahn im sichtbaren Randbereich eines berührungsempfindlichen Displays mit Hilfe eines Klebers K aufgeklebt werden kann. Dies ist insbesondere dann in vorteilhafter Weise möglich, wenn das Trägermaterial TM und die auf dem Trägermaterial angeordneten Elektroden und die Leiterbahn aus im Wesentlichen transparentem Material bestehen.

**Fig. 3** zeigt in einer Draufsicht die Elektrodenkonfiguration für einen berührungssensitiven Bildschirm.

In dieser Ausführungsform kann die Sensorelektrode E aus vier Elektrodensegmenten EX1, EX2, EY1 und EY2 bestehen. Dabei ist jedes Elektrodensegment mittels einer Leiterbahn L mit einer Auswerteelektronik A verbunden. Die Elektrodensegmente sind jeweils randseitig an der Anzeigeeinrichtung angeordnet, d.h. die Elektrodensegmente EY1 und EY2 sind am linken Rand bzw. am rechten Rand des Bildschirms angeordnet und die Elektrodensegmente EX1 und EX2 sind am oberen Rand bzw. am unteren Rand des Bildschirms angeordnet. Damit lässt sich in vorteilhafter Weise nicht nur die Annäherung eines Fingers bzw. einer Hand an eine Anzeigeeinrichtung detektieren, sondern auch die Position des Fingers bzw. der Hand relativ zur Anzeigeeinrichtung.

Wie aus Fig. 3 deutlich erkennbar ist, ist zwischen den Leiterbahnen L und den Elektrodensegmenten jeweils eine Schirmelektrode SE2 angeordnet, welche das von den jeweiligen Elektrodensegmenten emittierte elektrische Wechselfeld gegen die Leiterbahnen L abschirmt. In der in Fig. 3 gezeigten Ausführungsform handelt es sich um einen berührungsempfindlichen Bildschirm, bei welchem vor dem sichtbaren Bereich des Bildschirms eine leitfähige Beschichtung vorhanden ist, mit welcher die Berührung des Bildschirms detektiert werden kann.

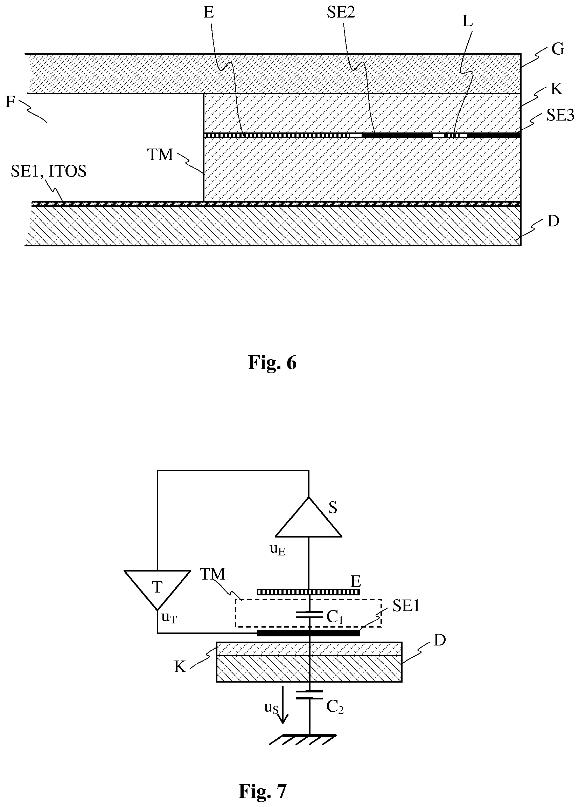

Beispielsweise kann es sich hierbei um einen resistiven Touchscreen handeln. Wie mit Bezug auf Fig. 1 bereits erläutert, ist hier die leitfähige Beschichtung des Bildschirms mit der ersten Schirmelektrode SE1 galvanisch oder kapazitiv gekoppelt. Wie aus Fig. 6 ersichtlich, kann die leitfähige Beschichtung des berührungsempfindlichen Bildschirms gleichzeitig auch die erste Schirmelektrode SE1 bilden, so dass ein insgesamt noch flacherer Aufbau einer Elektrodenanordnung möglich wird, um ein berührungsempfindliches Display mit der Funktionalität einer Annäherungs- bzw. Gestendetektion zu erweitern.

In **Fig. 4** ist ein Ausschnitt der in Fig. 3 gezeigten Elektrodenkonfiguration dargestellt. Mit Bezug auf Fig. 4 wird nachfolgend beispielhaft die Dimensionierung der Elektroden bzw. der Leiterbahnen erläutert.

Ein Augenmerk kann auf die Ausführung der Leiterbahnen L zum Anbinden der Elektroden an die Auswerteelektronik gerichtet werden. Dabei ist insbesondere eine schmale Leiterbahnbreite vorteilhaft, um die Empfindlichkeit der Elektrodenanordnung bestmöglich räumlich auf die Elektrodenflächen zu begrenzen.

Die zweite Schirmelektrode SE2 ist breit im Verhältnis zur Breite der Leiterbahn L ausgestaltet. Damit wird die Sensorelektrode bestmöglich gegen die Leiterbahn L abgeschirmt.

Um eine höchstmögliche Empfindlichkeit des gesamten Sensorsystems zu bekommen, wird auch die Breite A der Sensorelektrode möglichst groß gewählt. Der Einfluss der Leiterbahn L auf die Sensorelektrode kann noch weiter verringert werden, indem der Abstand B der Leiterbahn L zur Sensorelektrode möglichst groß gewählt wird. Die Breiten der Sensorelektrode EX1 bzw. der Schirmelektrode SE2 können variieren, solange die Breite der Schirmelektrode SE2 größer ist als die Breite der Leiterbahn L. Eine besonders vorteilhafte Konfiguration der Elektroden und der Leiterbahn L wird dann erreicht, wenn die Leiterbahn L, wie in Fig. 4 ersichtlich, im Verhältnis sowohl zur Schirmelektrode SE2 als auch zur Sensorelektrode EX1 besonders schmal ausgestaltet ist.

Eine besonders vorteilhafte Konfiguration wird erreicht, wenn die Breiten der zweiten Schirmelektrode SE2 und der Sensorelektrode besonders groß gewählt werden im Verhältnis zur Breite der Leiterbahn L und gleichzeitig die Breite der Sensorelektrode gleich groß oder größer ist als die Breite der zweiten Schirmelektrode SE2. Damit wird einerseits eine gute Abschirmung der Sensorelektrode gegen die Leiterbahn L und andererseits eine gute Empfindlichkeit der Sensorelektrode erreicht.

Abhängig von dem die Elektroden umgebenden Material ist es auch möglich, die zweite Schirmelektrode SE2 geringfügig breiter als die Sensorelektrode auszugestalten, wobei auch hier die Leiterbahn L besonders schmal ausgestaltet werden sollte.

**Fig. 5** zeigt eine erfindungsgemäße Elektrodenkonfiguration für eine Anzeigeeinrichtung. Die in Fig. 5 gezeigte Elektrodenkonfiguration ist insbesondere bei kleinen Anzeigeeinrichtungen gut einsetzbar, da die Breite der vier Elektrodensegmente EX1, EX2, EY1 und EY2 bzw. die Flächen der vier Elektrodensegmente so gewählt werden können, dass auch in der Mitte des Bildschirms eine Annäherung bzw. eine Geste sicher detektierbar ist. Eine leitfähige Beschichtung des Bildschirms ist dabei nicht notwendig. Damit lässt sich beispielsweise ein elektronischer Bilderrahmen um eine Annäherungs- bzw. Gestendetektionsmöglichkeit erweitern. Eine weitere Anwendung der in Fig. 5 gezeigten Elektrodenkonfiguration ist etwa die Anordnung der Elektrodenkonfiguration an einem Display eines Navigationsgerätes. In dieser Ausführungsform ist es vorteilhaft, die Elektrodensegmente so breit wie möglich auszuführen, um auch in der Mitte des Bildschirms eine gute Detektion zu ermöglichen.

**Fig. 6** zeigt den Schichtenaufbau einer erfindungsgemäßen Elektrodenanordnung, wie sie beispielsweise bei Anzeigeeinrichtungen eingesetzt werden kann, welche über keine leitfähige Beschichtung verfügen. Mit dieser Anordnung bzw. mit dieser Konfiguration lässt sich auch die Sensivität bei kleineren Bildschirmen, wie mit Bezug auf Fig. 5 beschrieben, noch weiter erhöhen. Insbesondere können mit dieser Konfiguration auch großflächige Anzeigeeinrichtungen mit einer Annäherungs- bzw. Gestendetektionsmöglichkeit erweitert werden, wobei auch bei großflächigen Anzeigeeinrichtungen eine Detektion im Bereich der Mitte der Anzeigeeinrichtung sicher gewährleistet ist.

An der Oberseite des Trägermaterials TM ist, wie bereits mit Bezug auf Fig. 1 und Fig. 2 gezeigt, eine Sensorelektrode E, eine zweite Schirmelektrode SE2, die Leiterbahn L und eine dritte Schirmelektrode SE3 angeordnet. An der Unterseite des Trägermaterials TM ist eine leitfähige Schicht ITOS angeordnet, welche auf einer Seite des Trägermaterials über das Trägermaterial hinausgeführt ist, also in den sichtbaren Bereich einer Anzeigeeinrichtung hineinragt bzw. den sichtbaren Bereich der Anzeigeeinrichtung vollständig abdeckt.

Die leitfähige Schicht ITOS ist vorzugsweise als transparente Schicht, wie sie beispielsweise bei berührungsempfindlichen Displays eingesetzt wird, ausgestaltet. Die leitfähige Schicht ITOS übernimmt hier die Funktion der mit Bezug auf die Figuren 1 und 2 gezeigten ersten Schirmelektrode SE1. Damit ist eine Folie realisierbar, welche beispielsweise auf eine Anzeigeeinrichtung aufgeklebt werden kann, wobei die Elektroden E, SE2, SE3 und die Leiterbahn L randseitig an der Folie angeordnet sind, wie beispielsweise mit Bezug auf Fig. 3 gezeigt. Somit kann auch bei Anzeigeeinrichtungen, welche über keine leitfähige Beschichtung verfügen, das an der Sensorelektrode E emittierte elektrische Wechselfeld gegen die Masse der Anzeigeeinrichtung abgeschirmt werden.

**Fig. 7** zeigt ein kapazitives Ersatzschaltbild eines erfindungsgemäßen kapazitiven Sensors mit einer Sensorelektrode E und einer ersten Schirmelektrode SE1.

Zwischen einer Sensorelektrode E und der ersten Schirmelektrode SE1 wirkt eine Kapazität C1. Die erste Schirmelektrode SE1 wiederum weist eine Kapazität C2 gegenüber dem geerdeten Bildschirm D auf.

Die Abschirmwirkung durch die erste Schirmelektrode SE1 wird erreicht, indem der Treiber T auf die erste Schirmelektrode SE1 geschaltet wird. Wenn die Ausgangsspannung $u_T$ des Treibers T näherungsweise der Elektrodenspannung $u_E$ an der Sensorelektrode E entspricht, ergibt sich eine besondere gute Abschirmwirkung.

Der dargestellte kapazitive Sensor S (es können auch mehrere Sensoren vorgesehen sein) kann nach einem Phasenverfahren arbeiten, bei dem die Phasenverschiebung eines Resonanzkreises des kapazitiven Sensors gegenüber einem Referenzsignal eines Generators des kapazitiven Sensors indikativ für die Annäherung ist. Bei Annäherung eines Fingers an eine Sensorelektrode E eines kapazitiven Sensors S wird der Resonanzkreis des kapazitiven Sensors infolge der Kapazitätsänderung aus der ursprünglich eingestellten Resonanz verstimmt. Dabei kommt es zu einer Amplituden- und Phasenänderung des Signals des Resonanzkreises bezüglich des Generatorsignals, mit welchem der Resonanzkreis beaufschlagt wird.

Amplituden- und Phasenänderung können zur Detektion einer Annäherung an den kapazitiven Sensor S bzw. an dessen Sensorelektrode E verwendet werden. Am vorteilhaftesten wird jedoch die Phasenlage ausgenutzt, weil man damit weitgehend unabhängig von möglichen Amplitudenänderungen des Generatorsignals bleibt und zudem eine noch größere Empfindlichkeit hinsichtlich Kapazitätsänderungen der Sensorelektrode E erreicht. Ferner kann bei Anwendung des Phasenverfahrens die Spannung am Resonanzkreis niedrig gehalten werden, was sich vorteilhaft auf die Feldemission an der Sensorelektrode E auswirkt und damit auch die EMV-Problematik bezüglich der Strahlungsemission vermindert. Des Weiteren ist ein Phasenverfahren auch unempfindlicher gegen von außen einwirkende Störungen auf der Empfangsseite.

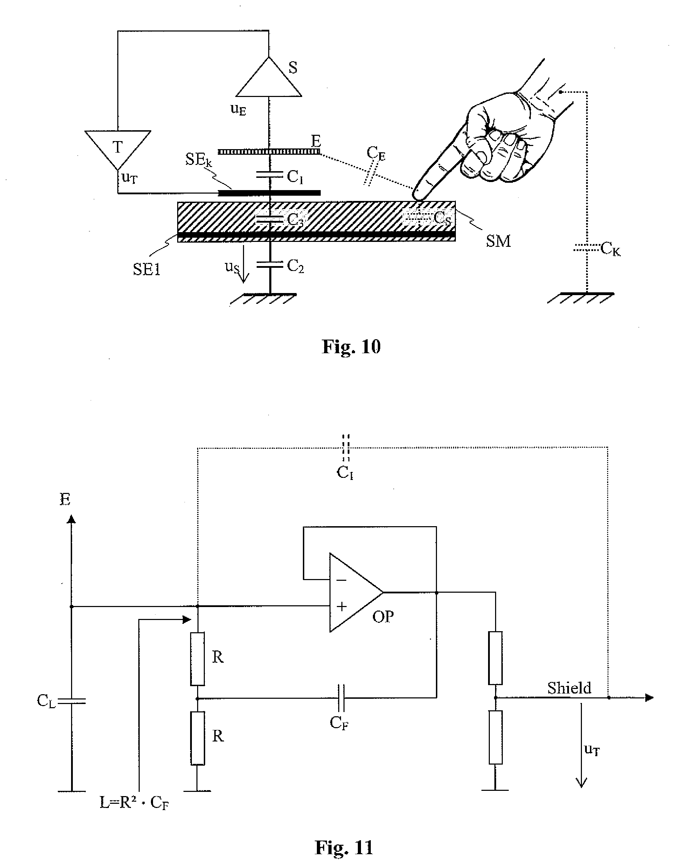

Die für einen Resonanzkreis eines kapazitiven Sensors S erforderliche induktive Komponente kann mittels eines Gyrators realisiert werden. Die Grundstruktur eines Gyrators für einen kapazitiven Sensor in einem erfindungsgemäßen System ist mit Bezug auf Fig. 11 dargestellt.

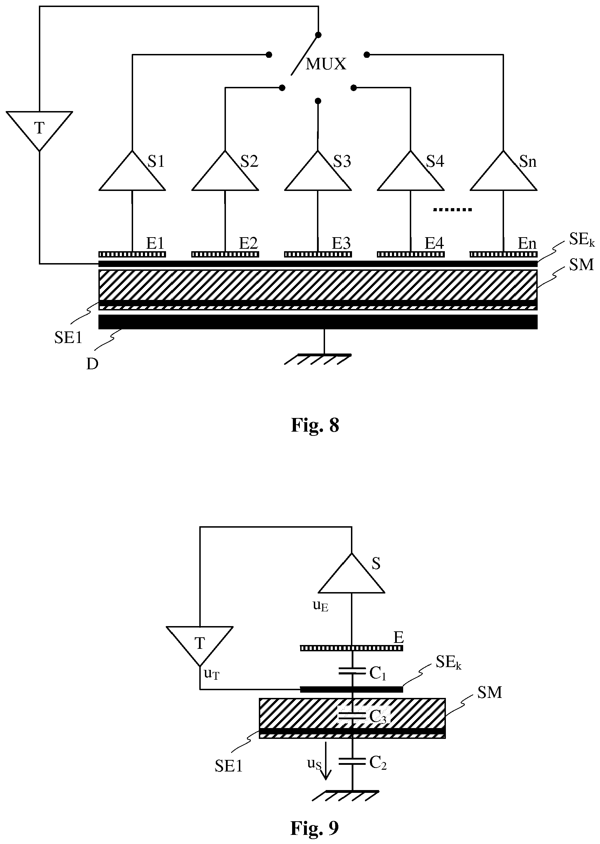

**Fig. 8** zeigt eine Prinzipanordnung eines erfindungsgemäßen Systems bzw. einer erfindungsgemäßen Schaltungsanordnung.

Die Anordnung umfasst Sensorelektroden E1 bis En, welche jeweils mit einem zugehörigen kapazitiven Sensor S1 bis Sn gekoppelt sind. Über dem Bildschirm bzw. Display D ist ein transparentes Schutzmaterial SM angeordnet. Das Schutzmaterial SM kann entweder aus Glas oder aus einer Folie aus Kunststoff gefertigt sein. Andere hierfür geeignete Materialien können ebenfalls verwendet werden.

An der Unterseite oder der Oberseite (oder nahe unterhalb einer Oberfläche) des Glases bzw. der Folie ist eine schwach leitende Schicht aufgebracht, die als Schirmelektrode SE1 der Abschirmung des von den Sensorelektroden S1 bis Sn emittierten elektrischen Feldes gegenüber dem geerdeten Bildschirm D dient. Diese leitende Schicht wirkt gegenüber dem geerdeten Bildschirm D jeweils dann als Abschirmung bzw. als Schirmelektrode SE1, wenn die an den Sensorelektroden E1 bis En anliegende Elektrodenspannung annähernd gleich der an der Schirmelektrode SE1 anliegenden Spannung ist. Die Schirmelektrode SE1 und die Sensorelektroden E1 bis En liegen dann auf annähernd gleichem Potential, sodass der Raum zwischen der Schirmelektrode SE1 und den Sensorelektroden E1 bis En nahezu feldfrei wird.

Die Schirmelektrode SE1 kann dabei Bestandteil der Anzeigeinrichtung bzw. des Bildschirms D sein, während die Sensorelektroden E1 bis En unabhängig von der Schirmelektrode SE1 auf dem Bildschirm D angebracht werden können bzw. nachträglich angebracht werden können.

Um auch bei einem von der Schirmelektrode SE1 unabhängigen Anbringen der Sensorelektroden E1 bis En zu gewährleisten, dass diese auf im Wesentlichen dem gleichen Potential liegen bzw. dass zwischen diesen ein im Wesentlicher feldfreier Raum gebildet wird, wird jeweils einer der Sensorausgänge der kapazitiven Sensoren S1 bis Sn über einen Multiplexer MUX und einer Treiberschaltung T auf eine Koppelelektrode $SE_K$ geschaltet.

Die Koppelelektrode $SE_K$ wird dabei derart angeordnet, dass sie zwischen den Sensorelektroden E1 bis En und der Schirmelektrode SE1 liegt und vorzugsweise mit der Schirmelektrode SE1 in kapazitive Koppelung bringbar ist. In einer anderen, hier nicht gezeigten Ausführungsform kann die Schirmelektrode SE1 galvanisch mit der Koppelelektrode $SE_K$ gekoppelt sein.

Die Treiberschaltung T ist dabei ausgestaltet, den Strom der Koppelelektrode $SE_K$ zu treiben und die Koppelelektrode $SE_K$ mit einer Spannung zu beaufschlagen, welche phasengleich zur an den Sensorelektroden E1 bis En anliegenden Elektrodenspannung ist. Das so an der Koppelelektrode $SE_K$ erzeugte Signal wird kapazitiv über das Glas oder die Folie auf die elektrisch leitende Schicht bzw. auf die Schirmelektrode SE1 gekoppelt. Damit wird gewährleistet, dass sich in jedem Fall ein im Wesentlichen feldfreier Raum zwischen den Sensorelektroden E1 bis En und der Schirmelektrode SE1 ausbildet.

Die kapazitive Ankoppelung von der Oberseite des Glases bzw. der Folie ist aus Sicht einer kostengünstigen Produktion besonders vorteilhaft, da die gesamte Konfiguration aus Sensorelektroden E1 bis En und Koppelelektrode $SE_K$ zur Ankoppelung an die Schirmelektrode SE1 von oben einfach auf den Bildschirm D aufgesetzt werden kann. Dies spielt vor allem auch unter dem Aspekt der Nachrüstung von Bildschirmen mit einer Annäherungsfunktionalität eine wichtige Rolle.

Die Wirkungsweise der in Fig. 8 gezeigten elektrischen Schaltung wird mit Bezug auf Fig. 9 näher erläutert.

**Fig. 9** zeigt ein kapazitives Ersatzschaltbild der in Fig. 8 gezeigten Schaltung für einen kapazitiven Sensor S.

Zwischen einer Sensorelektrode E und der Koppelelektrode $SE_K$ wirkt eine Kapazität $C_1$. Eine weitere Kapazität $C_3$ wird zwischen der Koppelelektrode $SE_K$ und der zur Abschirmung dienenden leitfähigen Schicht bzw. Schirmelektrode SE1 im Glas bzw. in der Folie SM gebildet. Die Schirmelektrode SE1 wiederum weist eine Kapazität $C_2$ gegenüber dem geerdeten Bildschirm D auf.

Für die Abschirmwirkung der Schirmelektrode SE1 ist die an der Schirmelektrode SE1 anliegende Spannung us maßgeblich. Bei einer Ausgangsspannung $u_T$ am Treiber T ergibt sich die Spannung us dann aus

$$u_S = u_T / (1 + C_2/C_3)$$

Da die Ausgangsspannung $u_T$ des Treibers T näherungsweise der Elektrodenspannung $u_E$ an der Sensorelektrode E entspricht, ergibt sich eine umso bessere Abschirmwirkung, je kleiner das Verhältnis $C_2/C_3$ ist. Dies lässt sich durch konstruktive Maßnahmen, etwa durch Wahl geeigneter Abstände zwischen den Sensorelektroden E und der Schirmelektrode SE1 erreichen. Es hat sich herausgestellt, dass man bereits bei einem Verhältnis von 1 für $C_2/C_3$ eine hohe Abschirmwirkung erzielt.

Aus Fig. 9 ist auch ersichtlich, dass über die Koppelkapazität $C_1$ zwischen Sensorelektrode E und Koppelelektrode $SE_K$ eine Rückkopplung im Sensorkreis auftritt, da über die Treiberschaltung T zum Sensor S eine Schleife gebildet wird. Dieser Effekt kann vorteilhaft für eine Erhöhung der Sensorempfindlichkeit ausgenutzt werden.

Die Verwendung einer leitfähigen Schicht bzw. einer Schirmelektrode SE1 im Glas bzw. auf einer Folie SM bietet zudem die Möglichkeit, mit dem erfindungsgemäßen System nach Fig. 8 außer einer Annäherungsdetektion auch eine Berührungsdetektion zu realisieren, die entweder unabhängig vom Ort der Berührung etwa eine Schaltfunktion ermöglicht oder abhängig vom Ort der Berührung auf dem Bildschirm für eine Koordinatenberechnung der Fingerposition verwendet werden kann. Besonders vorteilhaft lässt sich mit dem in Fig. 8 gezeigten System eine Gestendetektion verwirklichen. Die Berührungsdetektion wird mit Bezug auf Fig. 10 näher erläutert.

**Fig. 10** zeigt ein kapazitives Ersatzschaltbild für einen kapazitiven Sensor mit einem sich dem kapazitiven Sensor annähernden Finger bzw. mit einem das Display berührenden Finger.

Die Berührung des Glases oder der Folie SM bewirkt stets eine sprunghafte oder sehr schnelle Verringerung der Spannung us an der Schirmelektrode SE1, da die Schirmelektrode SE1 über eine vom Finger ausgehende Kopplungskapazität $C_S$ und über die Körperkapazität $C_K$ gegen Erde zusätzlich kapazitiv belastet wird. Diese Verringerung der Spannung $u_S$ ist gleichbedeutend einer Erhöhung der an einer Sensorelektrode E wirksamen Lastkapazität. Dementsprechend ändert sich auch die Signalspannung des Sensors S sprunghaft oder sehr schnell. Gleichzeitig bewirkt eine Berührung des Bildschirms auch eine kapazitive Kopplung zur Sensorelektrode E, die in Fig. 10 mit einer weiteren Koppelkapazität $C_E$ dargestellt ist. Nähert man sich bei gleichzeitigem Berühren des Displays der Sensorelektrode E, ergibt dies eine zusätzliche Änderung der Signalspannung des Sensors S, wodurch auch die Distanz des Fingers zur Sensorelektrode E ermittelt werden kann.

In Verbindung mit den übrigen Sensorelektroden kann damit die Koordinate des Fingers auf dem Bildschirm bestimmt werden. Dies ist jedoch mit hinreichender Genauigkeit nur dann möglich, wenn die Kopplung $C_S$ des Fingers gegenüber der Schirmelektrode SE1 im Vergleich zur Kopplung $C_E$ des Fingers auf die Sensorelektrode E nicht zu stark überwiegt.

Dies lässt sich durch eine entsprechende Gestaltung der Elektrodenkonfiguration erreichen, indem die Schirmelektrode SE1 näher oder weiter entfernt von der dem Bildschirm abgewandten Oberfläche des Glases oder der Folie SM angeordnet wird. Wird die Schirmelektrode SE1 weiter entfernt von der zu berührenden Oberfläche des Glases oder der Folie SM angeordnet, erhält man erfindungsgemäß die Möglichkeit einer unterscheidbaren Berührung auf dem Bildschirm. Die genaue Elektrodenkonfiguration hängt jeweils von der Größe des Bildschirms ab.

**Fig. 11** zeigt die Grundstruktur eines Gyrators für einen kapazitiven Sensor in einem erfindungsgemäßen System.

Ein über einen Kondensator $C_F$ rückgekoppelter Operationsverstärker OP wirkt am Eingang als virtuelle Induktivität $L = R^2 \cdot C_F$, die zusammen mit der dort angeschlossenen Sensorelektrode E und deren Lastkapazität $C_L$ gegen Masse einen Parallelschwingkreis bildet und dadurch als sensitives Element hinsichtlich der beschriebenen Phasenverschiebung wirkt. Gleichzeitig dient der Ausgang des Operationsverstärkers OP dazu, die über den Multiplexer MUX von Fig. 8 angeschlossene Koppelelektrode $SE_K$ bzw. die Schirmelektrode SE1, welche ja kapazitiv mit der Koppelelektrode $SE_K$ gekoppelt ist, zu treiben.

Da über die Kapazität $C_1$ zwischen der Sensorelektrode E und der Koppelelektrode $SE_K$ von Fig. 9 eine Rückkopplungsschleife entsteht und dadurch die Anordnung zur Oszillation neigen würde, wird mittels eines Dämpfungsgliedes, das vorzugsweise als ohmscher Spannungsteiler ausgebildet ist, die Ausgangsspannung des Operationsverstärkers OP heruntergeteilt, sodass das Verhältnis zwischen der Ausgangsspannung des Operationsverstärkers OP und der Spannung $u_T$ an der Koppelelektrode $SE_K$ betragsmäßig kleiner eins ist. Damit wird ein stabiler Betrieb gewährleistet. Zusätzlich kann der Ausgang des Operationsverstärkers OP mit der Treiberschaltung T gekoppelt werden, um optional die Spannung, mit welcher die Koppelelektrode $SE_K$ beaufschlagt wird, wieder zu erhöhen und um die Koppelelektrode $SE_K$ frei von einer kapazitiven Last zu bekommen.

Bei Verwendung des in Fig. 11 gezeigten Gyrators als induktive Komponente des Resonanzkreises eines kapazitiven Sensors S kann in einer Ausführungsform des erfindungsgemäßen Systems nach Fig. 8 bzw. Fig. 9 dieses auch ohne Treiberschaltung T realisiert werden, da der ohmscher Spannungsteiler selbst als Verstärker mit einem Verstärkungsfaktor kleiner 1 wirkt und die Koppelelektrode $SE_K$ treibt.

Diese Anordnung hat zudem den Vorteil, über diese Rückkopplung den Schwingkreis zu entdämpfen und somit eine hohe Kreisgüte zu erreichen, was wiederum eine hohe Annäherungsempfindlichkeit gewährleistet. Diese einfache und kostengünstige elektronische Realisierung eines Parallelschwingkreises ermöglicht auch eine Integration des gesamten Systems in einem ASIC.

Entsprechend der in Fig. 8 gezeigten Prinzipanordnung eines erfindungsgemäßen Systems mit mehreren kapazitiven Sensoren können erfindungsgemäß beliebige Elektrodenkonfigurationen bestehend aus Sensorelektroden, Koppelelektroden und Schirmelektroden realisiert werden, um eine Annäherung oder eine Bewegung (z.B. eine Gestik) im Bereich der Sensorelektroden zu erfassen.

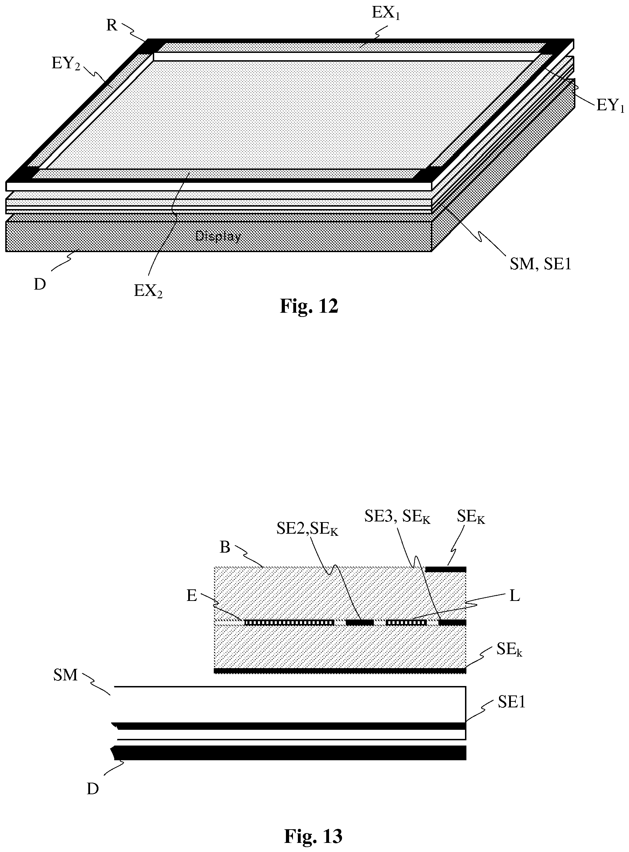

Ein Beispiel für eine Anordnung bestehend aus vier linienförmigen Elektroden $EX_1$, $EX_2$, $EY_1$, $EY_2$ in einem Mehrlagenaufbau ist in **Fig. 12** gezeigt. Fig. 12 zeigt eine rahmenförmige Anordnung R, welche zur Nachrüstung für eine Annäherungsfunktionalität (oder Gestik-Funktion) von oben auf ein Display D aufgesetzt werden kann. Die streifenförmigen Elektroden $EX_1$, $EX_2$, $EY_1$, $EY_2$ sind hier entlang der vier äußeren Kanten des Rahmens R angeordnet.

Der Schichtenaufbau der in Fig. 12 gezeigten rahmenförmigen Anordnung, welcher z.B. mit mehreren übereinander angeordneten Folien realisiert werden kann, ist in **Fig. 13** schematisch dargestellt.

Die Sensorelektrode E und mehrere Koppelelektroden $SE_K$ sind in einem Trägermaterial B eingebettet. Das Trägermaterial kann beispielsweise eine Folie, welche durchsichtig sein kann, sein. Die Koppelelektroden $SE_K$ sind galvanisch miteinander verbunden und werden von derselben Treiberschaltung T getrieben.

Die an der Oberseite des Trägermaterials randseitig angeordnete Koppelelektrode ermöglicht hierbei eine Abschirmwirkung nach außen zum Randbereich des Displays D. Die an der Unterseite des Trägermaterials angeordnet Koppelelektrode dient zusammen mit der in das Glas oder die Folie SM eingelassene Schirmelektrode SE1 dazu die Sensorelektrode E gegen das Display abzuschirmen.

Die streifenförmige Anordnung hat den Vorteil, dass die Koordinaten der Position eines Fingers mit einem einfachen Algorithmus für ein X/Y-Koordinatensystem auf der Display-Oberfläche berechnet werden können, da z.B. die Signale, welche an den X-Elektroden $EX_1$ und $EX_2$ entstehen, unabhängig von den Signalen an den Y-Elektroden $EY_1$ und $EY_2$ sind.

Eine Koordinatenberechnung mit vier streifenförmigen Sensorelektroden kann beispielsweise anhand einer

Auswertung der Phasenlage $\Phi_X$ bzw. $\Phi_Y$ der X-Elektroden bzw. der Y-Elektroden erfolgen. Dazu wird vorteilhaft die Phasendifferenz und die Phasensumme der X- bzw. der Y-Elektrodenpaare ermittelt, also

$$\Delta\Phi_X = \Phi_{X1} - \Phi_{X2} \qquad \text{und} \qquad \Sigma\Phi_X = \Phi_{X1} + \Phi_{X2}$$

bzw.

$$\Delta\Phi_Y = \Phi_{Y1} - \Phi_{Y2} \qquad \text{und} \qquad \Sigma\Phi_Y = \Phi_{Y1} + \Phi_{Y2}.$$

Damit ist auch eine Linearisierung der Koordinatenbestimmung möglich, da sich bei der Differenzbildung im Allgemeinen ein nichtlinearer Verlauf der Phasendifferenz ergibt. Für die Linearisierung kann zunächst (für jedes Elektrodenpaar) eine Funktion

$$\Psi_X = \Sigma\Phi_X - \Phi_{X0}$$

$$\Psi_Y = \Sigma\Phi_Y - \Phi_{Y0}$$

definiert werden. Daraus kann

$$\Delta\Phi_X/\Psi_X = (\Phi_{X1} - \Phi_{X2}) / (\Phi_{X1} + \Phi_{X2} - \Phi_{X0})$$

$$\Delta\Phi_Y/\Psi_Y = (\Phi_{Y1} - \Phi_{Y2}) / (\Phi_{Y1} + \Phi_{Y2} - \Phi_{Y0})$$

mit einer geeignet gewählten Konstante $\Phi_{X0}$ bzw. $\Phi_{Y0}$ gewählt werden, um die Linearisierung für jeweils in X-Richtung und Y-Richtung zu erhalten. Durch die sich daraus ergebende annähernde Proportionalität kann sehr einfach die Position eines Fingers bestimmt werden.

Mit der in Fig. 12 und Fig. 13 gezeigten rahmenförmigen Struktur, welche aus der Schicht SM mit der Schirmelektrode SE1 und der Schicht B mit den Sensorelektroden und den Koppelelektroden $SE_K$ besteht, kann auf sehr einfache Weise ein bestehendes Display um die Funktionalität einer Annäherungsbestimmung oder Gestenbestimmung erweitert werden.

Ebenso lässt sich erfindungsgemäß das System in ein bestehendes Display integrieren, indem bereits im Display vorhandene elektrisch leitfähige Strukturen auch für das erfindungsgemäße System verwendet werden.

Damit können beispielsweise resistive berührungsempfindliche Displays einfach um die genannte Funktionalität erweitert werden, indem die bereits vorhandenen leitfähigen Strukturen des berührungsempfindlichen Displays genutzt werden.

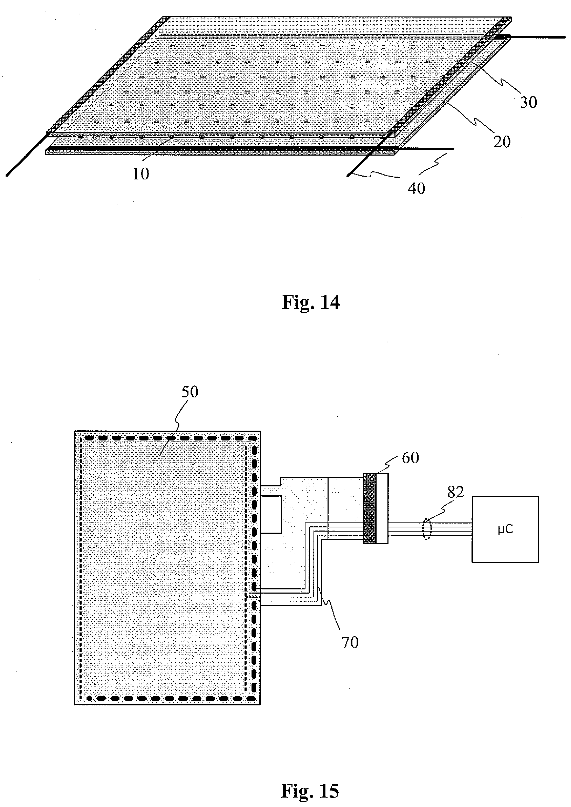

**Fig. 14** zeigt den Aufbau eines resistiven berührungsempfindlichen Displays (Touchscreen). Das resistive berührungsempfindliche Display besteht im Wesentlichen aus zwei gegenüberliegenden leitfähigen Schichten 20, 30 (Folie - Folie oder ITO-Glas - Folie), welche durch kleine Abstandsdots 10 voneinander getrennt sind. Das berührungsempfindliche Display wird oberhalb der Anzeigeeinrichtung angeordnet. Das berührungsempfindliche Display verfügt über Messleitungen, welche bei einer Berührung mit dem Finger oder Stift über den Berührungspunkt eine Spannung leiten.

**Fig. 15** zeigt die Koppelung des in Fig. 14 gezeigten resistiven berührungsempfindlichen Displays über Displayanschlusskabel 70 und einem Stecker 60 mit einer Auswerteeinheit $\mu$C zur Detektion von Berührungen.

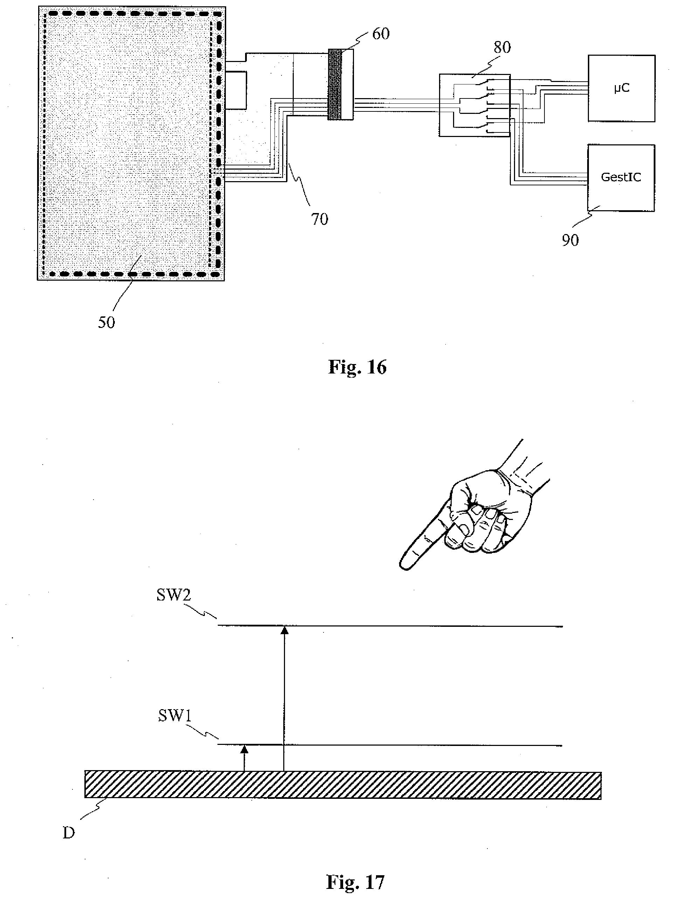

Erfindungsgemäß können die leitfähigen Schichten eines Touchscreens (unabhängig von der konkreten Touchscreenausführung) als Elektrodenstrukturen, insbesondere als erste Schirmelektrode SE1 für die erfindungsgemäße Elektrodenanordnung verwendet werden. Um die vorhandene Funktion der Berührungsdetektion des Touchscreen beizubehalten, wird die vorhandene Funktion der Berührungsdetektion im Zeitmultiplexverfahren mit einer erfindungsgemäßen Auswerteeinheit GestIC zur Näherungsdetektion gekoppelt. Eine derartige Koppelung ist in **Fig. 16** gezeigt.

**Fig. 17** zeigt ein Beispiel für eine Annäherungs- und Berührungsdetektion in Abhängigkeit von dem Abstand eines Objektes zu einem berührungssensitiven Bildschirm.

In dem hier gezeigten Beispiel werden zwei Schaltschwellen SW1 und SW2 definiert. Die Schaltschwellen geben einen ersten Abstand SW1 und einen zweiten Abstand SW2 zum berührungssensitiven Bildschirm D an.

Eine sich dem berührungssensitiven Bildschirm D annähernde menschliche Hand oder Finger kann vor dem berührungssensitiven Bildschirm D bzw. in dem von der erfindungsgemäßen Elektrodenanordnung erfassten Bereich Bewegungen durchführen, welche von der Elektrodenanordnung erfasst werden und ausgewertet werden können. Die Auswertung kann eine Gestenerkennung umfassen.

Ist der Abstand der Hand bzw. des Fingers zum Bildschirm D größer als der zweite Abstand SW2, wird die Auswerteeinheit μC zur Detektion von Berührungen deaktiviert. Die Auswerteeinheit GestIC zur Näherungsdetektion ist aktiviert, um Bewegungen vor dem Bildschirm zu erfassen.

Nähert sich die Hand bzw. der Finger weiter dem Bildschirm an, sodass der Abstand der Hand / des Fingers kleiner als der zweite Abstand SW2 und größer als der erste Abstand SW1 ist, sind die Auswerteeinheit μC und die Auswerteeinheit GestIC aktiviert. Damit können einerseits Bewegungen oder Gesten erfasst werden. Andererseits ist auch sichergestellt, dass eine schnelle Annäherung an den Bildschirm bzw. ein schnelles Berühren des Bildschirms durch die Auswerteeinheit μC verlässlich detektiert wird.

Nähert sich die Hand bzw. der Finger noch weiter dem Bildschirm D, sodass der Abstand der Hand / des Fingers kleiner als der erste Abstand SW1, wird die Auswerteeinheit GestIC deaktiviert. Die Auswerteeinheit μC zur Detektion von Berührungen bleibt weiter aktiviert. Dadurch kann verhindert werden, dass Bewegungen sehr nahe vor dem Bildschirm, welche zu einem Berühren des Bildschirms führen, in die Auswertung der Bewegung mit einfließen. Der Abstand SW1 kann sehr klein gewählt werden. Vorzugsweise liegt der Abstand SW1 im Bereich einiger Millimeter. Je nach Anwendungsgebiet kann der Abstand SW1 aber auch im Bereich einiger Zentimeter liegen.

In dem hier gezeigten Beispiel werden die Auswerteeinheit μC zur Detektion von Berührungen und die Auswerteeinheit GestIC zur Näherungsdetektion aktiviert bzw. deaktiviert, um die entsprechende Funktionalität bereitzustellen bzw. nicht bereitzustellen. Die Aktivierung der Auswerteeinheiten μC bzw. GestIC kann etwa dadurch erfolgen, dass diese mit der entsprechenden Betriebsspannung versorgt werden.

Alternativ zum Aktivieren bzw. Deaktivieren der Auswerteeinheiten GestIC kann diese auch so angepasst werden, dass sie die entsprechende Funktionalität jeweils nur in Abhängigkeit des Abstandes des Objektes zum Bildschirm ausführt. Die Auswerteeinheit GestIC wertet dann die erfassten Bewegungen nur dann aus, wenn der Abstand des Fingers größer als der erste Abstand SW1 ist. Ist der Abstand kleiner als der erste Abstand SW1, werden die Bewegungen zwar erfasst aber nicht ausgewertet. Besonders vorteilhaft ist es, wenn bei einem Abstand kleiner als SW1 von der erfassten Bewegung nur die Bewegung entlang der Z-Achse, also der Abstand des Fingers zum Bildschirm, ausgewertet wird.

Die Auswerteeinheiten GestIC und μC sind dabei immer aktiv und sind wie mit Bezug auf Fig. 16 gezeigt mit den entsprechenden Elektroden gekoppelt.

Erfindungsgemäß bestehen mehrere Möglichkeiten der Realisierung, wobei immer mindestens eine leitfähige Schicht des berührungsempfindlichen Displays entweder als Sensorelektrode E oder als Schirmelektrode genutzt wird.

Eine erste Möglichkeit besteht darin, die untere, dem Bildschirm D zugewandte Schicht 20 als Schirmelektrode zu nutzen und die obere Schicht 30 als Sensorelektrode E. Damit kann ohne zusätzliche Elektroden ein resistives berührungsempfindliches Display nachgerüstet werden. Die Schirmelektrode bildet hierbei gleichzeitig auch die Koppelelektrode $SE_K$.

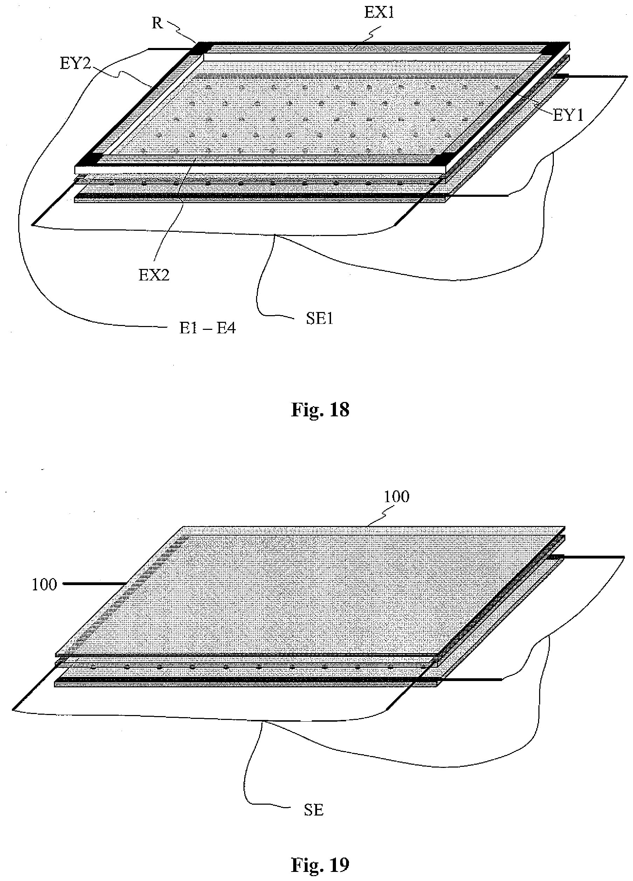

Eine weitere, in **Fig. 18** gezeigte Möglichkeit besteht darin, zwei leitfähige Schichten eines resistiven berührungsempfindlichen Displays zusammen als eine gemeinsame erste Schirmelektrode zu nutzen. Alternativ kann auch nur eine der beiden leitfähigen Schichten als erste Schirmelektrode genutzt werden. Die für den Aufbau notwendigen Sensorelektroden EX1, EX2, EY1, EY2 können als separates Teil am Bildschirm angeordnet werden. Hierbei kann eine Ausführung als Rahmenstruktur zu Anwendung kommen, wobei auf der Rahmenstruktur lediglich die Sensorelektroden, die zweiten Schirmelektroden und die Leiterbahnen angeordnet sind. Es kann auch eine einzelne umlaufende Sensorelektrode angeordnet werden, womit eine einfache Annäherung an das Display ohne Positionsbestimmung ermöglicht wird. Die Rahmenstruktur kann beispielsweise mittels Press- oder Clipkontaktierung galvanisch mit der Auswerteeinheit gekoppelt werden.

Eine weitere Möglichkeit besteht darin, mindestens eine leitfähige Schicht des resistiven berührungsempfindlichen Displays als Schirmelektrode zu verwenden und die Sensorelektrode E in Form einer zusätzlichen leitfähigen Folie 100 (z.B. ITO-Folie) auszugestalten und auf den bestehenden Touchscreen aufzubringen, wie in **Fig. 19** dargestellt. In der in Fig. 19 gezeigten Ausführungsform wird eine einzige Sensorelektrode E als durchgängig leitfähige Folie auf den Touchscreen aufgebracht. Damit lässt sich in einfacher Weise einfache Annäherung an das Display ohne Positionsbestimmung realisieren.

Alternativ kann auch eine Folie mit mehreren voneinander unabhängigen Sensorelektroden E bzw. eine Folie mit segmentierten Sensorelektroden E auf den Touchscreen aufgebracht werden, beispielsweise mit 4 oder 16 quadratisch oder rechteckig ausgestalteten Sensorelektroden. Möglich sind auch mehrere parallel verlaufende streifenförmig ausgestaltete Sensorelektroden, sodass vorteilhaft etwa die X-Position des sich annähernden Fingers detektierbar ist. Mit steigender Anzahl der Sensorelektroden lässt sich die Auflösung der Detektion, etwa einer Geste weiter erhöhen.

Dies hat den Vorteil, dass mindestens eine Elektrodenfläche des erfindungsgemäßen Systems eingespart werden kann, die volle Funktionalität der Annäherungs- bzw. Gestenerkennung durch Verwenden der leitfähigen Strukturen des Touchscreens dennoch mit einer besseren Empfindlichkeit als bei Systemen aus dem Stand der Technik bereitgestellt werden kann. Dadurch ergibt sich auch eine erheblich einfachere mechanische Integration, was gleichbedeutend mit einer erheblichen Kostenreduktion im Herstellungsprozess sowie bei den Materialkosten ist.

Durch die Erfindung wird es vorteilhaft möglich, beispielsweise Gerätefunktionen ohne Berühren des Geräts auszulösen. Damit können etwa Funktionen eines Navigationsgerätes in einem Kraftfahrzeug aufgerufen werden, ohne den Blick vom Verkehrsgeschehen abzuwenden, was die Sicherheit im Verkehr erhöht. Ein Schalter oder eine Schaltfläche auf einem Touchscreen des Navigationsgerätes kann dennoch betätigt werden.

Durch die berührungslose Bedienung ist es etwa auch möglich, einen elektronischen Bilderrahmen zu bedienen, ohne ihn durch Fingerabdrücke zu verschmutzen. Der ästhetische Gesamteindruck dieses Geräts wird auch bei intensiver Benutzung nicht beeinträchtigt. Das Bedienen eines elektronischen Bilderrahmens kann etwa ein Umschalten von anzuzeigenden Bildern umfassen. Zudem kann die Anbringung eines elektronischen Bilderrahmens oder seine Aufstellung ohne Rücksichtnahme darauf erfolgen, dass er beim Berühren oder Schalten eines Bedienelements verrutschen oder von der Wand fallen würde. Der elektronische Bilderrahmen kann damit auch in Bereichen angebracht werden, bei denen der Benutzer keinen direkten Zugriff auf an der Rückseite des Geräts angebrachte Bedienelemente hat, wie es bei bekannten elektronischen Bilderrahmen der Fall ist. Der Benutzer muss nur noch in die Nähe des Gerätes gelangen können, um es mit Gesten zu bedienen bzw. zu steuern.

Die Erfindung zeichnet sich durch eine hohe Flexibilität, insbesondere bei der Anpassung an verschiedene Bildschirmgrößen aus, ohne dass die Empfindlichkeit bei größeren Displays abnimmt. In weiteren, hier nicht gezeigten Ausführungsformen können auch mehrere Elektrodensegmente vorgesehen werden, um auch komplizierte Gesten zu detektieren. Dadurch, dass die Elektrodenanordnung aus nur zwei Elektrodenschichten, d.h. den Elektroden und der Leiterbahn an der Oberseite des Trägermaterials und der Elektrode an der Unterseite des Trägermaterials, besteht, ist eine besonders einfache mechanische Integration in das Zielsystem möglich, da die gesamte Elektrodenanordnung besonders flach ausgeführt werden kann. Zudem ist die Herstellung einer zweilagigen Elektrodenkonfiguration auf einem Trägermaterial, wie durch die Erfindung vorgeschlagen, besonders einfach und kostengünstig realisierbar. Durch Bereitstellung einer leitfähigen Folie, auf welche das Trägermaterial TM und die Elektroden aufgebracht sind, können zudem verschiedenste Anzeigeeinrichtungen um eine Gesten- bzw. Annäherungsfunktionalität erweitert werden.

**Patentansprüche**

1. Kapazitive Sensoranordnung für eine Anzeigeeinrichtung (D) zum Erfassen einer Position und/oder einer Annäherung eines Objektes an der/die Anzeigeeinrichtung (D), umfassend ein Traegermaterial (TM) mit einer Elektrodenanordnung, wobei die Elektrodenanordnung eine Sensorelektrode (E), eine erste Schirmelektrode (SE 1) und eine zweite Schirmelektrode (SE2) aufweist, wobei

   - die Sensorelektrode (E) ausgelegt ist ein elektrisches Wechselfeld abzustrahlen und wobei die kapazitive Sensoranordnung adaptiert ist eine Veränderung des abgestrahlten elektrischen Wechselfeldes, welche indikativ für eine Annäherung bzw. eine Position eines Objektes ist, zu detektieren,
   - die Sensorelektrode (E) und die zweite Schirmelektrode (SE2) auf einer ersten Seite (TM) des im Wesentlichen flächig ausgestalteten Trägermaterials (TM) mit einer ersten Seite und einer zweiten Seite angeordnet sind, und
   - die erste Schirmelektrode (SEI) auf der zweiten Seite des Trägermaterials (TM) angeordnet ist,

   wobei die kapazitive Sensoranordnung zur Anordnung an der Anzeigeeinrichtung (D) derart konfiguriert ist, dass die zweite Seite des Trägermaterials (TM) der Anzeigeeinrichtung (D) zugewandt ist, wobei die erste Schirmelektrode (SEI) der Abschirmung des von der Sensorelektrode (E) emittierten elektrischen Wechselfeldes gegenüber der geerdeten Anzeigeeinrichtung (D) dient, wobei die zweite Schirmelektrode zur Abschirmung des von der Sensorelektrode emittierten elektrischen Wechselfeldes dient und wobei die Elektrodenanordnung randseitig um die Anzeigeinrichtung umlaufend angeordnet ist.

2. Kapazitive Sensoranordnung nach Anspruch 1, wobei

   - die Sensorelektrode (E) mittels einer Leiterbahn (L), welche auf der ersten Seite (TM1) des Trägermaterials (TM) angeordnet ist, mit einer Auswerteelektronik (A) koppelbar ist,
   - die zweite Schirmelektrode (SE2) zwischen der Sensorelektrode (E) und der Leiterbahn (L) und beabstandet zur Sensorelektrode (E) und zur Leiterbahn (L) angeordnet ist und zur Abschirmung des von der Sensorelektrode (E) emittierten elektrischen Wechselfeldes gegen die Leiterbahn (L) dient, und

- die Sensorelektrode (E), die zweite Schirmelektrode (SE2) und die Leiterbahn (L) jeweils streifenförmig ausgestaltet sind, wobei
- die zweite Schirmelektrode (SE2) breiter ist als die Leiterbahn (L);
- die Sensorelektrode (E) breiter ist als die Leiterbahn (L);
- die Sensorelektrode (E) breiter ist als die zweite Schirmelektrode (SE2).

3. Kapazitive Sensoranordnung nach einem der Ansprüche 1 bis 2, weiter aufweisend eine dritte Schirmelektrode (SE3), wobei die dritte Schirmelektrode (SE3) auf der ersten Seite des Trägermaterials (TM) beabstandet zur Leiterbahn (L) angeordnet ist, wobei die Leiterbahn (L) zwischen der zweiten Schirmelektrode (SE2) und der dritten Schirmelektrode (SE3) angeordnet ist.

4. Kapazitive Sensoranordnung nach Anspruch 3, mit einem Resonanzkreis, wobei die Sensorelektrode (E) mit dem Resonanzkreis gekoppelt ist, wobei das unter Einschluss der Sensorelektrode (E) und des Resonanzkreises gebildete System mit einer elektrischen Wechselspannung beaufschlagbar ist, wobei eine Phasenverschiebung einer elektrischen Wechselspannung des Resonanzkreises gegenüber der beaufschlagten elektrischen Wechselspannung indikativ für die Annäherung und/oder die Position des Objektes an der Sensorelektrode (E) ist, wobei ein Ausgang des unter Einschluss der Sensorelektrode (E) und des Resonanzkreises gebildeten Systems über eine Verstärkerschaltung auf zumindest eine der drei Schirmelektroden (SE1, SE2, SE3) schaltbar ist, um zumindest eine der drei Schirmelektroden (SE1, SE2, SE3) im Wesentlichen auf das elektrische Potential der Sensorelektrode (E) zu bringen.

5. Kapazitive Sensoranordnung nach Anspruch 4, mit einer Koppelelektrode (SEK), wobei

- zumindest die Koppelelektrode (SEK) zwischen der Sensorelektrode (E) und der ersten Schirmelektrode (SE1) angeordnet ist und mit der ersten Schirmelektrode (SE1) gekoppelt ist; und der Ausgang des zumindest einen kapazitiven Sensors (S) über die Verstärkerschaltung auf die Koppelelektrode (SEK) geschaltet ist, um die Koppelelektrode (SEK) und die erste Schirmelektrode (SE1) im Wesentlichen auf das elektrische Potential der Sensorelektrode (E) zu bringen.

6. Kapazitive Sensoranordnung nach Anspruch 5, wobei die Schirmelektrode (SE) und die Koppelelektrode (SEK) kapazitiv koppelbar sind.

7. Kapazitive Sensoranordnung nach einem der vorhergehenden Ansprüche, wobei die erste Schirmelektrode (SE1) mit einer vor der Anzeigeeinrichtung (D) angeordneten leitfähigen und weitgehend transparenten Schicht (ITOS) galvanisch oder kapazitiv koppelbar ist.

8. System mit einer kapazitive Sensoranordnung nach einem der vorhergehenden Ansprüche, wobei das System eine Anzeigeeinrichtung (D) umfasst, welche ein berührungssensitiver Bildschirm ist und wobei die erste Schirmelektrode (SE1) und/oder die zumindest eine Sensorelektrode (E) durch die leitfähigen Schichten des berührungssensitiven Bildschirms gebildet werden, wobei die leitfähigen Schichten des berührungssensitiven Bildschirms mit einer Auswerteeinheit zur Berührungsdetektion ($\mu$C) und mit einer Auswerteeinheit zur Annäherungsdetektion (GestIC) gekoppelt sind.

9. System nach Anspruch 8, wobei die erste Schirmelektrode (SEI) durch eine vor der Anzeigeeinrichtung (D) angeordneten leitfähigen und weitgehend transparenten Schicht (ITOS) gebildet wird.

10. System nach Anspruch 8, wobei die leitfähigen Schichten des berührungssensitiven Bildschirms im Zeitmultiplexverfahren mit der Auswerteeinheit zur Berührungsdetektion ($\mu$C) und mit der Auswerteeinheit zur Annäherungsdetektion (GestIC) gekoppelt sind.

11. Kapazitive Sensoranordnung oder System nach einem der Ansprüche 5 bis 10, wobei die erste Schirmelektrode (SE1) die Koppelelektrode (SEK) umfasst.

12. Kapazitive Sensoranordnung oder System nach einem der vorhergehenden Ansprüche, wobei die Sensorelektrode (E), die zweite Schirmelektrode (SE2) und die Leiterbahn (L) im Wesentlichen parallel zueinander angeordnet sind.

13. Kapazitive Sensoranordnung nach Anspruch 1, wobei die Sensoranordnung als Folie ausgestaltet ist, aufweisend zumindest eine Koppelelektrode (SEK), wobei die Sensorelektroden (E) auf einer Seite der zumindest einen Koppelelektrode (SEK) und in einem vorbestimmten Abstand zur zumindest einen Koppelelektrode (SEK) angeordnet sind, wobei die Koppelelektrode (SEK) zwischen der Sensorelektrode (E) und der ersten Schirmelektrode (SE1) angeordnet ist, wobei die Folie Anschlüsse aufweist zum Anschließen der Sensorelektroden (E) an eine Auswerteeinheit (GestIC) und zum Anschließen der Sensorelektroden (E) und der zumindest einen Koppelelektrode (SEK) an eine Treiberschaltung (T) zur Herstellung eines im Wesentlichen feldfreien Raumes zwischen den Sensorelektroden (E) und der zumindest einen Koppelelektrode (SEK).

14. Verfahren zur Herstellung einer annäherungssensitiven Anzeigeeinrichtung mit einem berührungssensitiven Bildschirm, wobei der berührungssensitive Bildschirm leitfähige Strukturen zur Detektion einer Berührung aufweist, umfassend einen Schritt zum Aufbringen einer Folie gemäß Anspruch 13 auf den berührungssensitiven Bildschirm, wobei die zumindest eine Koppelelektrode (SEK) dem Bildschirm zugewandt wird und wobei die zumindest eine Koppelelektrode (SEK) mit den leitfähigen Strukturen des berührungssensitiven Bildschirms in eine kapazitive Koppelung gebracht werden.

15. Verfahren nach Anspruch 14, weiter aufweisend:
einen Schritt zum Koppeln der Folienanschlüsse und der leitfähigen Strukturen des berührungssensitiven Bildschirms mit der Auswerteeinheit zur Annäherungsdetektion (GestIC), wobei die leitfähigen Strukturen im Zeitmultiplexverfahren mit der Auswerteeinheit zur Annäherungsdetektion (GestIC) und mit einer Auswerteeinheit zur Berührungsdetektion (µC) gekoppelt werden.

## Claims

1. A capacitive electrode arrangement for a display device (D) for detecting a position and/or an approach of an object towards the display device (D), comprising a substrate (TM) with an electrode arrangement, wherein the electrode arrangement comprises a sensor electrode (E), a first shielding electrode (SE1) and a second shielding electrode (SE2), wherein

   - the sensor electrode (E) is configured to emit an electric alternating field and wherein the capacitive electrode arrangement is adapted to detect a change of the emitted electric alternating field, which is indicative for an approach or a position of an object,
   - the sensor electrode (E) and the second shielding electrode (SE2) are arranged on a first side (TM) of the substantially two-dimensionally formed substrate (TM) comprising a first side and a second side, and
   - the first shielding electrode (SE1) is arranged on the second side of the substrate (TM),

   wherein the capacitive electrode arrangement for arrangement at the display device (D) is configured such, that the second side of the substrate (TM) is facing towards the display device (D), wherein the first shielding electrode (SE1) provides shielding of the electric alternating field emitted by the sensor electrode (E) from the grounded display device (D), wherein the second shielding electrode provides shielding of the electric alternating field emitted by the sensor electrode and wherein the electrode arrangement is arranged circumferential around the edge of the display device.

2. The capacitive electrode arrangement of claim 1, wherein

   - the sensor electrode (E) can be coupled with evaluation electronics (A) by means of a conductor path (L), which is arranged on the first side (TM1) of the substrate (TM),
   - the second shielding electrode (SE2) is arranged between the sensor electrode (E) and the conductor path (L) and spaced apart from the sensor electrode (E) and the conductor path (L) and provides shielding of the electric alternating field emitted by the sensor electrode (E) from the conductor path (L), and
   - the sensor electrode (E), the second shielding electrode (SE2) and the conductor path (L) each are formed strip-shaped, wherein
   - the second shielding electrode (SE2) is wider than the conductor path (L);
   - the sensor electrode (E) is wider than the conductor path (L);
   - the sensor electrode (E) is wider than the second shielding electrode (SE2).

3. The capacitive electrode arrangement of one of claims 1 to 2, further comprising a third shielding electrode (SE3), wherein the third shielding electrode (SE3) is arranged on the first side of the substrate (TM) and spaced apart from the conductor path (L), wherein the conductor path (L) is arranged between the second shielding electrode (SE2) and the third shielding electrode (SE3).

4. The capacitive electrode arrangement of claim 3, comprising a resonant circuit, wherein the sensor electrode (E) is coupled with the resonant circuit, wherein the system formed by inclusion of the sensor electrode (E) and the resonant circuit can be loaded with an electric alternating voltage, wherein a phase shift of an electric alternating voltage of the resonant circuit compared to the loaded electric alternating voltage is indicative for the approach and/or the position of the object at the sensor electrode (E), wherein an output of the system formed by inclusion of the the sensor electrode (E) and the resonant circuit is switchable to be coupled to at least one of the three shielding electrodes (SE1, SE2, SE3) via an amplifier circuit to substantially deliver the electric potential of the sensor electrode (E) to at least one of the three shielding electrodes (SE1, SE2, SE3).

5. The capacitive electrode arrangement of claim 4 comprising a coupling electrode (SEK), wherein

   - at least the coupling electrode (SEK) is arranged between the sensor electrode (E) and the first shielding electrode (SE1) and is coupled with the first shielding electrode (SE1); and
   - the output of the at least one capacitive sensor (S) is connected to the coupling electrode (SEK) via the amplifier circuit to substantially deliver the electric potential of the sensor electrode (E) to the coupling electrode (SEK) and the first shielding electrode (SE1).

6. The capacitive electrode arrangement of claim 5, wherein the shielding electrode (SE) and the coupling electrode (SEK) can be coupled capacitively.

7. The capacitive electrode arrangement of one of the preceding claims, wherein the first shielding electrode (SE1) can be coupled galvanically or capacitively with a conductive and widely transparent layer (ITOS) arranged in front of the display device (D).

8. A system comprising a capacitive electrode arrangement of one of the preceding claims, wherein the system comprises a display device (D), which is a touch-sensitive display and wherein the first shielding electrode (SE1) and/or the at least one sensor electrode (E) are formed by the conductive layers of the touch-sensitive display, wherein the conductive layers of the touch-sensitive display are coupled with an evaluation unit for touch detection ($\mu$C) and with an evaluation unit for approach detection (GestIC).

9. The system of claim 8, wherein the first shielding electrode (SE1) is formed by a conductive and widely transparent layer (ITOS) arranged in front of the display device (D).

10. The system of claim 8, wherein the conductive layers of the touch-sensitive display are coupled with the evaluation unit for touch detection ($\mu$C) and with the evaluation unit for approach detection (GestIC) in time division multiplex.

11. The capacitive electrode arrangement or the system of one of claims 5 to 10, wherein the first shielding electrode (SE1) comprises the coupling electrode (SEK).

12. The capacitive electrode arrangement or the system of one of the preceding claims, wherein the sensor electrode (E), the second shielding electrode (SE2) and the conductor path (L) substantially are arranged in parallel to each other.

13. The capacitive electrode arrangement of claim 1, wherein the sensor arrangement is formed as a foil comprising at least one coupling electrode (SEK), wherein the sensor electrodes (E) are arranged on one side of the at least one coupling electrode (SEK) and in a predefined distance to the at least one coupling electrode (SEK), wherein the coupling electrode (SEK) is arranged between the sensor electrode (E) and the first shielding electrode (SE1), wherein the foil has connections for connecting the sensor electrodes (E) to an evaluation unit (GestIC) and for connecting the sensor electrodes (E) and the at least one coupling electrode (SEK) to a driver circuit (T) for creating a substantially field-free space between the sensor electrodes (E) and the at least one coupling electrode (SEK).

14. A method for fabricating an approach-sensitive display device comprising a touch-sensitive display, wherein the touch-sensitive display has conductive structures for detecting a touch, comprising a step of applying a foil according to claim 13 onto the touch-sensitive display, wherein the at least one coupling electrode (SEK) faces towards the display and wherein the at least one coupling electrode (SEK) comprising the conductive structures of the touch-sensitive display is brought into capacitive coupling.

**15.** The method of claim 14, further comprising:
a step for coupling the foil connections and the conductive structures of the touch-sensitive display with the evaluation unit for approach detection (GestIC), wherein the conductive structures are coupled in time division multiplex with the evaluation unit for approach detection (GestIC) and with an evaluation unit for touch detection ($\mu$C).

**Revendications**

**1.** Disposition de capteurs capacitive pour un dispositif d'affichage (D) pour la détection d'une position et/ou d'une approche d'un objet vers le dispositif d'affichage (D), comprenant un matériau porteur (TM) avec une disposition d'électrodes, la disposition d'électrodes comprenant une électrode de capteur (E), une première électrode de blindage (SE1) et une deuxième électrode de blindage (SE2),

- l'électrode de capteur (E) étant conçue pour émettre un champ électrique alternatif et la disposition de capteurs capacitive étant conçue pour détecter une modification du champ électrique alternatif qui indique une approche ou une position d'un objet,
- l'électrode de capteur (E) et la deuxième électrode de blindage (SE2) étant disposées sur un premier côté (TM) du matériau porteur (TM) conçu de manière plane, avec un premier côté et un deuxième côté et
- la première électrode de blindage (SE1) est disposée sur le deuxième côté du matériau porteur (TM),

la disposition de capteurs capacitive destinée à être disposée sur le dispositif d'affichage (D) est configurée de façon à ce que le deuxième côté du matériau porteur (TM) soit orienté vers le dispositif d'affichage (D), la première électrode de blindage (SE1) sert au blindage du champ électrique alternatif émis par l'électrode de capteur (E) par rapport au dispositif d'affichage (D) mis à la terre, la deuxième électrode de blindage servant au blindage du champ électrique alternatif émis par l'électrode de capteur et la disposition d'électrodes étant disposée sur le bord autour du dispositif d'affichage.

**2.** Disposition de capteurs capacitive selon la revendication 1,

- l'électrode de capteur (E) pouvant être couplée, au moyen d'une piste conductrice (L), qui est disposée sur le premier côté (TM1) du matériau porteur (TM), avec une électronique d'analyse (A),
- la deuxième électrode de blindage (SE2) étant disposée entre l'électrode de capteur (E) et la piste conductrice (L) et distante de l'électrode de capteur (E) et de la piste conductrice (L) et sert au blindage du champ électrique alternatif émis par l'électrode de capteur (E) et
- l'électrode de capteur (E), la deuxième électrode de blindage (SE2) et la piste conductrice (L) présentent chacune la forme d'une bande,
- la deuxième électrode de blindage (SE2) étant plus large que la piste conductrice (L) ;
- l'électrode de capteur (E) étant plus large que la piste conductrice (L) ;
- l'électrode de capteur (E) étant plus large que la deuxième électrode de blindage (SE2).

**3.** Disposition de capteurs capacitive selon l'une des revendications 1 à 2, comprenant en outre une troisième électrode de blindage (SE3), la troisième électrode de blindage (SE3) étant disposée sur le premier côté du matériau porteur (TM) à une certaine distance de la piste conductrice (L), la piste conductrice (L) étant disposée entre la deuxième électrode de blindage (SE2) et la troisième électrode de blindage (SE3).

**4.** Disposition de capteurs capacitive selon la revendication 3, avec un circuit de résonance, l'électrode de capteur (E) étant couplée avec le circuit de résonance, le système formé par l'intégration de l'électrode de capteur (E) et du circuit de résonance pouvant être alimenté avec une tension électrique alternative, un décalage de phase d'une tension électrique alternative du circuit de résonance par rapport à la tension électrique alternative appliquée indiquant l'approche et/ou la position de l'objet vers l'électrode (E), une sortie du système formé par l'intégration de l'électrode de capteur (E) et du circuit de résonance pouvant être commutée par un circuit amplificateur à au moins une des trois électrodes de blindage (SE1, SE2, SE3), afin d'amener au moins une des trois électrodes de blindage (SE1, SE2, SE3) globalement au potentiel électrique de l'électrode de capteur (E).

**5.** Disposition de capteurs capacitive selon la revendication 4, avec une électrode de couplage (SEK),

- au moins l'électrode de couplage (SEK) étant disposée entre l'électrode de capteur (E) et la première électrode de blindage (SE1) et étant couplée avec la première électrode de blindage (SE1) ; et la sortie de l'au moins un capteur capacitif (S) étant commutée par l'intermédiaire du circuit amplificateur sur l'électrode de couplage (SEK), afin d'amener l'électrode de couplage (SEK) et la première électrode de blindage (SE1) globalement au potentiel électrique de l'électrode de capteur (E).

6. Disposition de capteurs capacitive selon la revendication 5, l'électrode de blindage (SE) et l'électrode de couplage (SEK) pouvant être couplées de manière capacitive.

7. Disposition de capteurs capacitive selon l'une des revendications précédentes, la première électrode de blindage (SE1) pouvant être couplée de manière galvanique ou capacitive avec une couche (ITOS) conductrice et largement transparente, disposée devant le dispositif d'affichage (D).

8. Système avec une disposition de capteurs capacitive selon l'une des revendications précédentes, le système comprenant un dispositif d'affichage (D) qui est un écran tactile et la première électrode de blindage (SEI) et/ou l'au moins une électrode de capteur (E) étant constituées des couches conductrices de l'écran tactile, les couches conductrices de l'écran tactile étant couplées avec une unité d'analyse pour la détection d'un contact ($\mu$C) et avec une unité d'analyse pour la détection d'une approche (GestIC).

9. Système selon la revendication 8, la première électrode de blindage (SEI) étant constituée d'une couche (ITOS) conductrice et largement transparente, disposée devant le dispositif d'affichage (D).

10. Système selon la revendication 8, les couches conductrices de l'écran tactile étant couplées, à l'aide d'un procédé de mutliplexage dans le temps, avec l'unité d'analyse pour la détection d'un contact ($\mu$C) et avec l'unité d'analyse pour la détection d'une approche (GestIC).

11. Disposition de capteurs capacitive ou système selon l'une des revendications 5 à 10, la première électrode de blindage (SE1) comprenant l'électrode de couplage (SEK).

12. Disposition de capteurs capacitive ou système selon l'une des revendications précédentes, l'électrode de capteur (E), la deuxième électrode de blindage (SE2) et la piste conductrice (L) étant disposées de manière globalement parallèle entre elles.

13. Disposition de capteurs capacitive selon la revendication 1, la disposition de capteurs étant conçue comme un film comprenant au moins une électrode de couplage (SEK), les électrodes de capteurs (E) étant disposées sur un côté de l'au moins une électrode de couplage (SEK) et à une distance prédéterminée de l'au moins une électrode de couplage (SEK), l'électrode de couplage (SEK) étant disposée entre l'électrode de capteur (E) et la première électrode de blindage (SE1), le film comprenant des branchements pour le raccordement des électrodes de capteurs (E) à une unité d'analyse (GestIC) et pour le raccordement des électrodes de capteurs (E) et de l'au moins une électrode de couplage (SEK) à un circuit pilote (T) pour l'établissement d'un espace globalement exempt de champ entre les électrodes de capteurs (E) et l'au moins une électrode de couplage (SEK).

14. Procédé de fabrication d'un dispositif d'affichage sensible à l'approche avec un écran tactile, l'écran tactile comprenant des structures conductrices pour la détection d'un contact, comprenant une étape d'application d'un film selon la revendication 13 sur l'écran tactile, l'au moins une électrode de couplage (SEK) étant orientée vers l'écran et l'au moins une électrode de couplage (SEK) étant mise en couplage capacitif avec les structures conductrices de l'écran tactile.

15. Procédé selon la revendication 14, comprenant en outre :
une étape de couplage des branchements du film et des structures conductrices de l'écran tactile avec l'unité d'analyse pour la détection d'une approche (GestIC), les structures conductrices étant couplées, à l'aide d'un procédé de multiplexage dans le temps, avec l'unité d'analyse pour la détection d'approche (GestIC) et avec une unité d'analyse pour la détection d'un contact ($\mu$C).

**Fig. 1**

**Fig. 2**

**Fig. 3**

**Fig. 4**

**Fig. 5**

**Fig. 6**

**Fig. 7**

**Fig. 8**

**Fig. 9**

**Fig. 10**

**Fig. 11**

**Fig. 14**

**Fig. 15**

**Fig. 16**

**Fig. 17**

**Fig. 18**

**Fig. 19**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090096761 A1
- US 20080018608 A1
- US 20060132462 A1